(19)

Europäisches Patentamt

European Patent Office

Office européen des brevets

(11) **EP 4 376 579 A1**

(12) **EUROPEAN PATENT APPLICATION**

(43) Date of publication:
**29.05.2024 Bulletin 2024/22**

(21) Application number: **23210406.7**

(22) Date of filing: **16.11.2023**

(51) International Patent Classification (IPC):
**H10K 59/80** (2023.01)        **H10K 77/10** (2023.01)
**H10K 102/00** (2023.01)

(52) Cooperative Patent Classification (CPC):
**H10K 77/111; H10K 59/873;** H10K 2102/311

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.11.2022   KR 20220157505
12.05.2023   KR 20230061733**

(71) Applicant: **Samsung Display Co., Ltd.
Yongin-si, Gyeonggi-do 17113 (KR)**

(72) Inventors:
• **Yoo, Jewon
17113 Yongin-si, Gyeonggi-do (KR)**

• **Kim, Dongjo
17113 Yongin-si, Gyeonggi-do (KR)**
• **Kim, Youngji
17113 Yongin-si, Gyeonggi-do (KR)**
• **Kim, Hyun
17113 Yongin-si, Gyeonggi-do (KR)**
• **Won, Seonggeun
17113 Yongin-si, Gyeonggi-do, (KR)**
• **Lee, Seungmin
17113 Yongin-si, Gyeonggi-do (KR)**
• **Hwang, Soukjune
17113 Yongin-si, Gyeonggi-do (KR)**

(74) Representative: **Gulde & Partner
Patent- und Rechtsanwaltskanzlei mbB
Wallstraße 58/59
10179 Berlin (DE)**

(54)     **DISPLAY APPARATUS AND METHOD OF MANUFACTURING DISPLAY APPARATUS**

(57)     Provided are a display apparatus and a method of manufacturing the display apparatus. The display apparatus includes a support substrate including a first support substrate and a second support substrate separated from each other, a substrate disposed on the support substrate, a display layer disposed on a portion of the substrate corresponding to the first support substrate, and a thin-film encapsulation layer disposed to cover the display layer, wherein one surface of the first support substrate and one surface of the second support substrate facing each other include a slope surface.

FIG. 5A

EP 4 376 579 A1

## Description

BACKGROUND

1. Field

One or more embodiments relate to an apparatus and a method, and more particularly, to a display apparatus and a method of manufacturing the display apparatus.

2. Description of the Related Art

Mobile electronic apparatuses are widely used. As mobile electronic apparatuses, recently, tablet personal computers (PCs) are widely used as well as miniaturized electronic apparatuses such as mobile phones.

To support various functions, for example, to provide a user with visual information, such as images, the mobile electronic apparatuses include a display apparatus. In a display apparatus, a display circuit board may be disposed on the rear surface of a display panel in order to increase a display area and miniaturize electronic apparatuses.

SUMMARY

In a display apparatus according to the related art, a substrate is bent to attach a display circuit board to the rear surface of a display panel, and a separate support substrate is used to support the substrate. In this case, an opening area is formed in the support substrate but a cross-section of the support substrate has a vertical shape in the opening area. Accordingly, while the substrate is bent, the substrate may be damaged or excessively supported, and thus, a curvature radius may increase. In addition, because a protective film is used to form the opening area, excessive foreign materials may remain on the display panel after the display panel is manufactured. Accordingly, the deterioration in the performance or defects of the display apparatus may be caused. One or more embodiments include a display apparatus that supports a substrate after the substrate is bent, and simultaneously, supports force applied to the substrate, with improved quality because less foreign materials occur while the display apparatus is manufactured, and a method of manufacturing the display apparatus.

Additional aspects will be set forth in part in the description which follows and, in part, will be apparent from the description, or may be learned by practice of the presented embodiments of the disclosure.

According to one or more embodiments, a display apparatus includes a support substrate including a first support substrate and a second support substrate separated from each other, a substrate disposed on the support substrate, a display layer disposed on a portion of the substrate corresponding to the first support substrate, and a thin-film encapsulation layer disposed to cover the display layer, wherein one surface of the first support substrate and one surface of the second support substrate facing each other include a slope surface.

One of the one surface of the first support substrate and the one surface of the second support substrate facing each other may include a groove formed in a direction away from the other of the one surface of the first support substrate and the one surface of the second support substrate facing each other.

A maximum width of the groove may be in a range exceeding 0 $\mu$m and equal to or less than 50 $\mu$m. The maximum width may be measured at points where the groove has the biggest width. The maximum width may preferably be in a range exceeding 0 $\mu$m and equal to or less than 40 $\mu$m, more preferably be in a range exceeding 0 $\mu$m and equal to or less than 30 $\mu$m. Further, the maximum width may be in a range exceeding 0 $\mu$m and equal to or less than 20 $\mu$m. The maximum width may be 10 $\mu$m.

Each of the first support substrate and the second support substrate may include a plurality of sides, and at least one of the plurality of sides of the first support substrate or at least one of the plurality of sides of the second support substrate may include the slope surface.

The display apparatus may further include a protective layer disposed on the support substrate and the substrate.

The protective layer may be arranged to overlap a region in which the first support substrate is apart from the second support substrate in a plan view.

The protective layer may include amorphous silicon.

The substrate may be bent.

The display apparatus may further include a bending protective layer disposed on a bent portion of the substrate.

According to one or more embodiments, a method of manufacturing a display apparatus includes disposing a second base substrate on a first base substrate, forming a display layer and a thin-film encapsulation layer on the second base substrate, forming a reference groove in the first base substrate, disposing an etching protective layer on the thin-film encapsulation layer, and forming an opening area by spraying an etching solution to the first base substrate and expanding the reference groove.

The method may further include forming the reference groove by removing a portion of the first base substrate with a cutter or a laser beam.

The method may further include forming a protective layer on the first base substrate.

The protective layer may overlap the reference groove in a plan view.

The protective layer may include amorphous silicon.

A depth of the reference groove may have a linear relationship with a taper angle of one surface of the first base substrate disposed around the expanded opening area.

The method may further include forming a groove in a boundary of one surface of the first base substrate defining the opening area.

A maximum width of the groove may be in a range exceeding 0 μm and equal to or less than 50 μm.

The method may further include disposing a bending protective layer on the second base substrate to overlap the opening area in a plan view.

The method may further include bending the second base substrate around an arbitrary bending axis overlapping the bending protective layer.

The method may further include separating the first base substrate and the second base substrate on which the display layer and the thin-film encapsulation layer are disposed from the first base substrate and the second base substrate based on a cutting line arranged in a portion apart from an edge of the display layer and the thin-film encapsulation layer.

According to one or more embodiments, a method of manufacturing a display apparatus includes disposing a second base substrate on a first base substrate, forming a display layer and a thin-film encapsulation layer on the second base substrate, forming a cutting groove in the second base substrate, disposing an etching protective layer on the thin-film encapsulation layer, and separating a portion of the first base substrate from another portion of the first base substrate along the cutting groove by spraying an etching solution to a surface of the first base substrate different from one surface of the first base substrate on which the display layer is disposed.

These and/or other aspects will become apparent and more readily appreciated from the following detailed description of the embodiments, the accompanying drawings, and claims.

These general and specific aspects may be implemented by using a system, a method, a computer program, or a combination of a certain system, method, and computer program.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic plan view of a display panel according to an embodiment;
FIG. 2 is a cross-sectional view of the display panel, taken along line II-II' of FIG. 1;
FIGS. 3 and 4 are circuit diagrams of the display panel shown in FIG. 1;
FIG. 5A is a schematic cross-sectional view of a display apparatus according to an embodiment;
FIG. 5B is a schematic perspective view of a support substrate and a substrate shown in FIG. 5A;
FIG. 5C is an enlarged backside view of a region A of FIG. 5B;
FIG. 6A is a schematic plan view showing manufacturing of a display apparatus according to an embodiment;
FIGS. 6B and 6C are schematic cross-sectional views showing manufacturing of a display apparatus taken along line B-B' of FIG. 6A according to an embodiment;
FIG. 6D is a schematic plan view showing manufacturing of a display apparatus according to an embodiment;
FIG. 6E is a schematic cross-sectional view showing manufacturing of a display apparatus taken along line C-C' of FIG. 6D according to an embodiment;
FIG. 7 is a schematic cross-sectional view of a display apparatus according to another embodiment;
FIG. 8A is a schematic plan view showing manufacturing of a display apparatus according to another embodiment;
FIGS. 8B and 8C are schematic cross-sectional views showing manufacturing of a display apparatus taken along line D-D' of FIG. 8A according to another embodiment;
FIG. 8D is a schematic plan view showing manufacturing of a display apparatus according to another embodiment;
FIGS. 8E to 8G are schematic cross-sectional views showing manufacturing of a display apparatus according to another embodiment;
FIG. 9 is a schematic cross-sectional view of a display apparatus according to another embodiment;
FIG. 10A is a schematic plan view showing manufacturing of a display apparatus according to another embodiment;
FIGS. 10B to 10D are schematic cross-sectional views showing manufacturing of a display apparatus taken along line E-E' of FIG. 10A according to another embodiment;
FIG. 11 is a schematic cross-sectional view of a display apparatus according to another embodiment;
FIG. 12A is a schematic perspective view of a portion of a display apparatus according to another embodiment;
FIG. 12B is an enlarged backside view of a region D of FIG. 12A;
FIG. 12C is a perspective view of a portion shown in FIG. 12A;
FIG. 12D is a cross-sectional view of an opening area shown in FIG. 12A;
FIGS. 13A to 13C are backside views of an opening area shown in FIG. 12A;
FIGS. 14A to 14D are views showing embodiments of a cutting unit used in a method of manufacturing a display apparatus according to an embodiment; and
FIGS. 15A and 15B are cross-sectional views of some of the manufacturing of the display apparatus according to another embodiment.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the disclosure allows for various changes and numerous embodiments, certain embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

Hereinafter, embodiments will be described with reference to the accompanying drawings, wherein like reference numerals refer to like elements throughout and a repeated description thereof is omitted.

While such terms as "first" and "second" may be used to describe various elements, such elements must not be limited to the above terms. The above terms are used to distinguish one element from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

Sizes of elements in the drawings may be exaggerated or reduced for convenience of explanation. As an example, the size and thickness of each element shown in the drawings are arbitrarily represented for convenience of description, and thus, the disclosure is not necessarily limited thereto.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

In the case where a certain embodiment may be implemented differently, a specific process order may be performed in the order different from the described order. As an example, two processes successively described may be simultaneously performed substantially and performed in the opposite order.

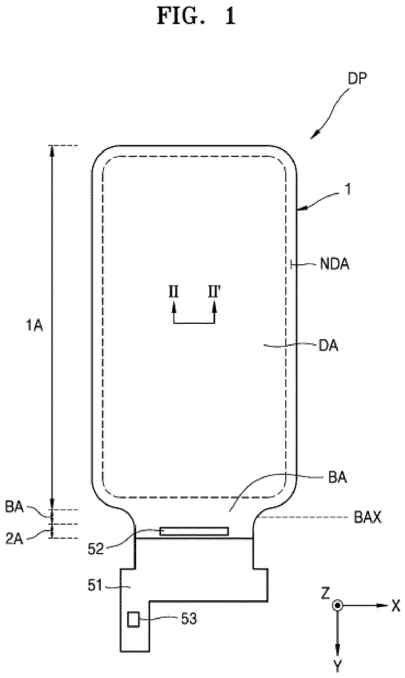

FIG. 1 is a schematic plan view of a display apparatus DP according to an embodiment.

Referring to FIG. 1, the display apparatus DP may include a display panel 1, a display circuit board 51, a display driver 52, and a touch sensor driver 53. The display panel 1 may be a light-emitting display panel including a light-emitting element. As an example, the display panel 1 may be an organic light-emitting display panel using an organic light-emitting diode that includes an organic emission layer, an ultra-miniature light-emitting diode display panel that uses a micro light-emitting diode, a quantum-dot light-emitting display panel that uses a quantum-dot light-emitting diode including a quantum-dot emission layer, or an inorganic light-emitting display panel that uses an inorganic light-emitting element including an inorganic semiconductor.

The display panel 1 may be a flexible display panel which has flexibility and thus is easily bendable, foldable, or rollable. As an example, the display panel 1 may include a foldable display panel that is foldable and unfoldable, a curved display panel that has a curved display surface, a bended display panel in which a region except a display surface is bent, a rollable display panel that is rollable and unrollable, and a stretchable display panel that is stretchable.

The display panel 1 may be a transparent display panel that is implemented to be transparent such that an object or background disposed below the display panel 1 is viewable from the upper surface of the display panel 1. Alternatively, the display panel 1 may be a reflective display panel that may reflect an object or background over the upper surface of the display panel 1.

The display panel 1 may include a display area DA and a peripheral area NDA arranged to surround the display area DA, wherein the display area DA is configured to display images. Separate driving circuit and pad, and the like may be arranged in the peripheral area NDA.

In addition, the display panel 1 may include a first area 1A, a bent area BA, and a second area 2A, wherein the first area 1A is arranged in the display area DA, the bent area BA is bent around a bending axis BAX, and the second area 2A is connected to the bent area BA and the display circuit board 51. In this case, the second area 2A and the bent area BA may be included in the peripheral area NDA. Images may not be displayed in the second area 2A and the bent area BA. The bent area BA connected to the first area 1A may be formed smaller than a length of one side of the first area 1A. The width of the bent area BA measured in an X axis direction of FIG. 1 may be reduced toward the second area 2A from the first area 1A and be constant in a preset region.

The display circuit board 51 may be attached to the edge on one side of the display panel 1. In this case, a separate pad portion may be disposed on one side of the display panel 1, and the pad portion may be connected to the display circuit board 51. In this case, one side of the display circuit board 51 may be attached to the edge of one side of the display panel 1 by using an anisotropic conductive film. In another embodiment, though not shown in the drawing, the display circuit board 51 may be connected to the display panel 1 through a flexible film. In this case, one of the ends of the flexible film may be connected to the display panel 1, and the other of the ends of the flexible film may be connected to the display circuit board 51. The flexible film may be a flexible film that is bendable. Hereinafter, for convenience of description, the case where the display circuit board 51 is directly connected to the display panel 1 is mainly described in detail.

The display circuit board 51 may be a flexible printed circuit board (FPCB) that is bendable, or a composite printed circuit board including both a rigid printed circuit board that is strong and not easily bent and a flexible printed circuit board.

In an embodiment, the display driver 52 may be disposed on the display panel 10. That is, the display driver 52 may be disposed on a substrate or a support substrate of the display panel 1. The display driver 52 may receive control signals and power voltages, generate and output signals and voltages for driving the display panel 1. The display driver 52 may include an integrated circuit (IC). In another embodiment, though not shown in the drawing, the display driver 52 may be disposed on the flexible film. Hereinafter, for convenience of description, the case where the display driver 52 is disposed on the display panel 1 is mainly described in detail.

The touch sensor driver 53 may be disposed on the display circuit board 51. The touch sensor driver 53 may include an integrated circuit. The touch sensor driver 53 may be attached to the display circuit board 51. The touch sensor driver 53 may be electrically connected to touch electrodes of a touch electrode layer of the display panel 1 through the display circuit board 51.

The touch electrode layer of the display panel 1 may sense a user's touch input by using at least one of various touch methods such as a resistance layer method, a capacitance method and the like. As an example, in the case where the touch electrode layer of the display panel 1 senses a user's touch input by using a capacitance method, the touch sensor driver 53 may determine whether a user touches the touchscreen layer by applying driving signals to driving electrodes among touch electrodes, and sensing voltages charged in a mutual capacitance between the driving electrodes and the sensing electrodes through the sensing electrodes among the touch electrodes. A user's touch may include a contact touch and a proximity touch. A contact touch denotes that an object such as a user's finger or a pen directly contacts a cover member disposed on the touch electrode layer. A proximity touch, like hovering, denotes that an object such as a user's finger or a pen is located near over the cover member, away from the cover window 70. The touch sensor driver 53 may be configured to transfer sensor data to a main processor according to sensed voltages, and the main processor may be configured to calculate touch coordinates at which a touch input occurs by analyzing the sensor data.

A power supply unit may be additionally disposed on the display circuit board 51, wherein the power supply unit is configured to supply driving voltages for driving the pixels of the display panel 1, the scan driver, and the display driver 52. Alternatively, the power supply unit may be integrated with the display driver 52. In this case, the display driver 52 and the power supply unit may be implemented in one integrated circuit.

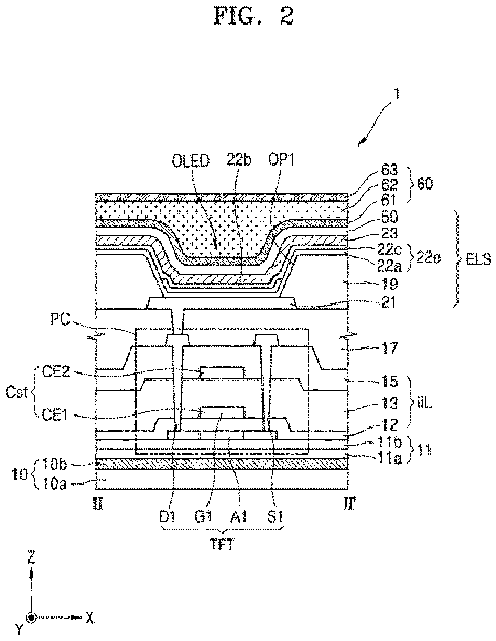

FIG. 2 is a cross-sectional view of the display panel, taken along line II-II' of FIG. 1. In this case, FIG. 2 is a schematic cross-sectional view of a portion of the display area DA of the display apparatus DP shown in FIG. 1.

Referring to FIG. 2, the display panel 1 may include a base substrate 10, a buffer layer 11, a circuit layer (not shown), and a display layer or display portion ELS including a display element layer (not shown). In addition, the display panel 1 may include an encapsulation member (not shown) shielding the display element layer.

The base substrate 10 may include an insulating material such as glass, quartz, and/or polymer resin and the like. The base substrate 10 may include a substrate 10b and a support substrate 10a. In this case, the support substrate 10a may include an insulating material such as glass and/or quartz and the like. The support substrate 10a may include portions separated from each other. As an example, the support substrate 10a may be separated into two or three portions.

The substrate 10b may include an insulating material such as polymer resin and the like. In this case, the substrate 10b may be a flexible substrate that is bendable, foldable, and rollable. In the case where the substrate 10b includes an insulating material such as polymer resin and the like, the substrate 10b may have a structure in which a layer including an organic material and a layer including an inorganic material are alternately stacked. As an example, the substrate 10b may include an organic layer and an inorganic layer, wherein the organic layer includes one of polyimide, polyethylene naphthalate, polyethylene terephthalate, polyarylate, polycarbonate, polyetherimide and polyethersulfone, and the inorganic layer includes at least one of silicon oxide, silicon oxynitride, and silicon nitride and amorphous silicon.

The buffer layer 11 may be disposed on a substrate 10b, may reduce or block penetration of foreign materials, moisture, or external air from below the substrate 10b, and provide a flat surface on the substrate 10b. The buffer layer 11 may include an inorganic material, an organic material, or an organic/inorganic composite material, and include a single layer or a multi-layer including an inorganic material and an organic material, the inorganic material including oxide or nitride. A barrier layer (not shown) may be further disposed between the substrate 10b and the buffer layer 11, the barrier layer blocking penetration of external air. In an embodiment, the buffer layer 11 may include silicon oxide ($SiO_2$) or silicon nitride ($SiN_x$). The buffer layer 11 may include a first buffer layer 11a and a second buffer layer 11b that are stacked.

The circuit layer may be disposed on the buffer layer 11 and may include a pixel circuit PC, a first gate insulating layer 12, a second gate insulating layer 13, an interlayer insulating layer 15, and a planarization layer 17. The pixel circuit PC may include a thin-film transistor TFT and a storage capacitor Cst.

The thin-film transistor TFT may be disposed on the buffer layer 11, wherein the thin-film transistor TFT may be connected to an organic light-emitting element OLED to drive the organic light-emitting element OLED. The thin-film transistor TFT may include a first semiconductor layer A1, a first gate electrode G1, a first source electrode S1, and a first drain electrode D1.

The first semiconductor layer A1 may be disposed on the buffer layer 11 and may include polycrystalline silicon. In another embodiment, the first semiconductor layer A1 may include amorphous silicon. In another embodiment, the first semiconductor layer A1 may include an oxide of at least one of indium (In), gallium (Ga), stannum (Sn), zirconium (Zr), vanadium (V), hafnium (Hf), cadmium (Cd), germanium (Ge), chromium (Cr), titanium (Ti), and zinc (Zn). The first semiconductor layer A1 may include a channel region, a source region, and a drain region, the source region and the drain region being doped with impurities.

The first gate insulating layer 12 may be provided to cover the first semiconductor layer A1. The first gate insulating layer 12 may include an inorganic insulating material, such as silicon oxide ($SiO_2$), silicon nitride ($SiN_x$), silicon oxynitride (SiON), aluminum oxide ($Al_2O_3$), titanium oxide ($TiO_2$), tantalum oxide (TazOs), hafnium oxide ($HfO_2$), or zinc oxide ($ZnO_x$). In this case, zinc oxide ($ZnO_x$) may be zinc oxide (ZnO) and/or zinc peroxide ($ZnO_2$). The first gate insulating layer 12 may include a single layer or a multi-layer including the inorganic insulating material.

The first gate electrode G1 is disposed on the first gate insulating layer 12 to overlap the first semiconductor layer A1. The first gate electrode G1 may include at least one of molybdenum (Mo), aluminum (Al), copper (Cu), titanium (Ti) and the like and include a single layer or a multi-layer. As an example, the first gate electrode G1 may include a single Mo layer.

The second gate insulating layer 13 may be provided to cover the first gate electrode G1. The second gate insulating layer 13 may include an inorganic insulating material, such as silicon oxide ($SiO_2$), silicon nitride ($SiN_x$), silicon oxynitride (SiON), aluminum oxide ($Al_2O_3$), titanium oxide ($TiO_2$), tantalum oxide ($Ta_2O_5$), hafnium oxide ($HfO_2$), or zinc oxide ($ZnO_x$). In this case, zinc oxide ($ZnO_x$) may be zinc oxide (ZnO) and/or zinc peroxide ($ZnO_2$). The second gate insulating layer 13 may include a single layer or a multi-layer including the inorganic insulating material.

A first upper electrode CE2 of the storage capacitor Cst may be disposed on the second gate insulating layer 13.

The first upper electrode CE2 may overlap the first gate electrode G1 therebelow in the display area DA. The first gate electrode G1 and the first upper electrode CE2 overlapping each other with the second gate insulating layer 13 therebetween may constitute the storage capacitor Cst. The first gate electrode G1 may serve as a first lower electrode CE1 of the storage capacitor Cst.

The first upper electrode CE2 may include aluminum (Al), platinum (Pt), palladium (Pd), silver (Ag), magnesium (Mg), gold (Au), nickel (Ni), neodymium (Nd), iridium (Ir), chrome (Cr), calcium (Ca), molybdenum (Mo), titanium (Ti), tungsten (W), and/or copper (Cu), and include a single layer or a multi-layer including the above materials.

The interlayer insulating layer 15 may be formed to cover the first upper electrode CE2. The interlayer insulating layer 15 may include silicon oxide ($SiO_2$), silicon nitride ($SiN_x$), silicon oxynitride (SiON), aluminum oxide ($Al_2O_3$), titanium oxide ($TiO_2$), tantalum oxide ($Ta_2O_5$), hafnium oxide ($HfO_2$), or zinc oxide ($ZnO_x$). The interlayer insulating layer 15 may include a single layer or a multi-layer including the inorganic insulating material. In this case, zinc oxide ($ZnO_x$) may be zinc oxide (ZnO) and/or zinc peroxide ($ZnO_2$).

The first source electrode S1 and the first drain electrode D1 may be disposed on the interlayer insulating layer 15. The first source electrode S1 and the first drain electrode D1 may each include a conductive material including molybdenum (Mo), aluminum (Al), copper (Cu), and titanium (Ti) and include a single layer or a multi-layer including the above materials. As an example, the first source electrode S1 and the first drain electrode D1 may each have a multi-layered structure of Ti/Al/Ti.

The planarization layer 17 may be disposed to cover the first source electrode S1 and the first drain electrode D1. The planarization layer 17 may have a flat top surface such that a pixel electrode 21 disposed thereon is formed flat.

The planarization layer 17 may include an organic material or an inorganic material and have a single-layered structure or a multi-layered structure. The planarization layer 17 may include a general-purpose polymer such as benzocyclobutene (BCB), polyimide, hexamethyldisiloxane (HMDSO), polymethylmethacrylate (PMMA) or polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof. The planarization layer 17 may include an inorganic insulating material, such as silicon oxide ($SiO_2$), silicon nitride ($SiN_x$), silicon oxynitride (SiON), aluminum oxide ($Al_2O_3$), titanium oxide ($TiO_2$), tantalum oxide ($Ta_2O_5$), hafnium oxide ($HfO_2$), or zinc oxide ($ZnO_x$). In this case, zinc oxide ($ZnO_x$) may be zinc oxide (ZnO) and/or zinc peroxide ($ZnO_2$). When forming the planarization layer 17, after a layer is formed, chemical mechanical polishing may be performed on an upper surface of the layer to provide a flat top surface.

The planarization layer 17 may include a via hole exposing one of the first source electrode S1 and the first drain electrode D1, and the pixel electrode 21 may be electrically connected to the thin-film transistor TFT by contacting the first source electrode S1 or the first drain electrode D1 through the via hole.

The pixel electrode 21 may include a conductive oxide, such as indium tin oxide (ITO), indium zinc oxide (IZO), zinc oxide (ZnO), indium oxide ($In_2O_3$), indium gallium oxide (IGO), or aluminum zinc oxide (AZO). The pixel electrode 21 may include a reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. As an example, the pixel electrode 21 may have a structure including layers on/under the reflective layer, the layers including ITO, IZO, ZnO, or $In_2O_3$. In this case, the pixel electrode 21 may have a stack structure of ITO/Ag/ITO.

A pixel-defining layer 19 may cover the edges of the pixel electrode 21 on the planarization layer 17 and include a first opening OP1 exposing the central portion of the pixel electrode 21. An emission area of the organic light-emitting element OLED, that is, the size and shape of a sub-pixel Pm are defined by the first opening OP1.

The pixel-defining layer 19 may prevent arcs and the like from occurring at the edges of each pixel electrode 21 by increasing a distance between the edges of each pixel electrode 21 and an opposite electrode 23 over the pixel electrode 21. The pixel-defining layer 19 may include an organic insulating material, such as polyamide, an acryl resin, benzocyclobutene, and hexamethyldisiloxane (HMDSO), and be formed by spin coating and the like.

An emission layer 22b is disposed in the inside of the first opening OP1 of the pixel-defining layer 19, wherein the emission layer 22b corresponds to each pixel electrode 21. The emission layer 22b may include a low-molecular weight material or a polymer material, and emit red, green, blue, or white light.

An organic functional layer 22e may be disposed on and/or under the emission layer 22b. The organic functional layer 22e may include a first functional layer 22a and/or a second functional layer 22c. The first functional layer 22a or the second functional layer 22c may be omitted.

The first functional layer 22a may be disposed under the emission layer 22b. The first functional layer 22a may include a single layer or a multi-layer including an organic material. The first functional layer 22a may be a hole transport layer (HTL) having a single-layered structure. Alternatively, the first functional layer 22a may include a hole injection layer (HIL) and a hole transport layer (HTL). The first functional layer 22a may be integrally formed to correspond to organic light-emitting elements OLED and OLED' included in the display area DA and a component area CA.

The second functional layer 22c may be disposed on the emission layer 22b. The second functional layer 22c may include a single layer or a multi-layer including an organic material. The second functional layer 22c may include an electron transport layer (ETL) and/or an electron injection layer (EIL). The second functional layer 22c may be integrally formed to correspond to the organic light-emitting elements OLED included in the display area DA.

The opposite electrode 23 is disposed on the second functional layer 22c. The opposite electrode 23 may include a conductive material having a low work function. As an example, the opposite electrode 23 may include a (semi) transparent layer including silver (Ag), magnesium (Mg), aluminum (Al), platinum (Pt), palladium (Pd), gold (Au), nickel (Ni), neodymium (Nd), iridium (Ir), chrome (Cr), or an alloy thereof. Alternatively, the opposite electrode 23 may further include a layer on the (semi) transparent layer, the layer including ITO, IZO, ZnO, or $In_2O_3$. The opposite electrode 23 may be integrally formed to correspond to the organic light-emitting elements OLED included in the display area DA.

Layers from the pixel electrode 21 to the opposite electrode 23 formed in the display area DA may constitute the organic light-emitting element OLED.

An upper layer 50 including an organic material may be formed on the opposite electrode 23. The upper layer 50 may be a layer for protecting the opposite electrode 23 and simultaneously increasing a light-extracting efficiency. The upper layer 50 may include an organic material having a higher refractive index than that of the opposite electrode 23. Alternatively, the upper layer 50 may include layers of different refractive indexes that are stacked. As an example, the upper layer 50 may include a high refractive index layer/a low refractive index layer/a high refractive index layer that are stacked. In this case, the refractive index of the high refractive index layer may be 1.7 or more, and the refractive index of the low refractive index layer may be 1.3 or less.

The upper layer 50 may additionally include lithium fluoride (LiF). Alternatively, the upper layer 50 may additionally include an inorganic insulating material such as silicon oxide ($SiO_2$) and silicon nitride ($SiN_x$). The upper layer 50 may be omitted when needed. However, for convenience of description, the case where the upper layer 50 is disposed on the opposite electrode 23 is mainly described in detail.

Though not shown in the drawing, the display apparatus DP may include the encapsulation member shielding the upper layer 50. In this case, the encapsulation member may include a thin-film encapsulation layer 60 shielding the upper layer 50.

The thin-film encapsulation layer 60 may be disposed on the upper layer 50 to directly contact the upper layer 50. In this case, the thin-film encapsulation layer 60 may be configured to prevent penetration of external moisture and oxygen by covering a portion of the display area DA and the peripheral area NDA. The thin-film encapsulation layer 60 may include at least one inorganic encapsulation layer and at least one organic encapsulation layer. Hereinafter, for convenience of description, the case where the thin-film encapsulation layer 60 includes a first inorganic encapsulation layer 61, an organic encapsulation layer 63, and a second inorganic encapsulation layer 63 that are sequentially stacked on the upper layer 50 is mainly described in detail.

In this case, the first inorganic encapsulation layer 61 may cover the opposite electrode 50 and may include silicon oxide, silicon nitride, and/or silicon oxynitride. Because the first inorganic encapsulation layer 61 is formed along a structure thereunder, the upper surface of the first inorganic encapsulation layer 61 is not flat. The organic encapsulation layer 62 may cover the first inorganic encapsulation layer 61 and, unlike the first inorganic encapsulation layer 61, the upper surface of the organic encapsulation layer 62 may be approximately flat. Specifically, the upper surface of a portion of the organic encapsulation layer 62 that corresponds to the display area DA may be approximately flat. The organic encapsulation layer 62 may include at least one material among polyethylene terephthalate, polyethylene naphthalate, polycarbonate, polyimide, polyethylene sulfonate, polyoxymethylene, polyarylate, and hexamethyldisiloxane. The second inorganic encapsulation layer 63 may cover the organic encapsulation layer 62 and may include silicon oxide, silicon nitride, and/or silicon oxynitride.

A touch electrode layer may be disposed on the thin-film encapsulation layer.

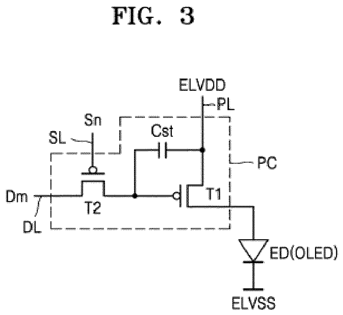

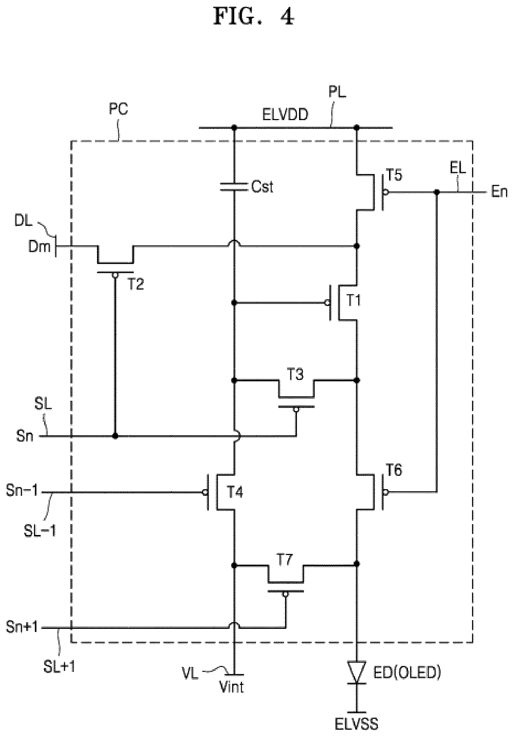

FIGS. 3 and 4 are circuit diagrams of the display panel shown in FIG. 1.

Referring to FIGS. 3 and 4, the pixel circuit PC may be connected to a light-emitting element ED to implement light emission of sub-pixels. In this case, the light-emitting element ED may include the organic light-emitting element OLED shown in FIG. 2. The pixel circuit PC may include a driving thin-film transistor T1, a switching thin-film transistor T2, and a storage capacitor Cst. The switching thin-film transistor T2 may be connected to a scan line SL and a data line DL, and configured to transfer a data signal Dm to the driving thin-film transistor T1 according to a scan signal Sn, wherein the data signal Dm is input through the data line DL, and the scan signal Sn is input through the scan line SL.

The storage capacitor Cst may be connected to the switching thin-film transistor T2 and a driving voltage line PL and configured to store a voltage corresponding to a difference between a voltage transferred from the switching thin-film transistor T2 and a driving voltage ELVDD supplied to the driving voltage line PL.

The driving thin-film transistor T1 may be connected to the driving voltage line PL and the storage capacitor Cst and configured to control a driving current according to the voltage stored in the storage capacitor Cst, the driving current flowing from the driving voltage line PL to the light-emitting element ED. The light-emitting element ED may be configured to emit light having a preset brightness corresponding to the driving current.

Though it is described with reference to FIG. 3 that the pixel circuit PC includes two thin-film transistors and one storage capacitor, the embodiment is not limited thereto.

Referring to FIG. 4, the pixel circuit PC may include the driving thin-film transistor T1, the switching thin-film transistor T2, a compensation thin-film transistor T3, a first initialization thin-film transistor T4, an operation control thin-film transistor T5, an emission control thin-film transistor T6, and a second initialization thin-film transistor T7.

Although it is shown in FIG. 4 that each pixel circuit PC includes signal lines SL, SL-1, SL+1, EL, and DL, an initialization voltage line VL, and the driving voltage line PL, the embodiment is not limited thereto. In another embodiment, at least one of the signal lines SL, SL-1, SL+1, EL, and DL, and/or the initialization voltage line VL may be shared by adjacent pixel circuits.

A drain electrode of the driving thin-film transistor T1 may be electrically connected to the light-emitting element ED through the emission control thin-film transistor T6. The driving thin-film transistor T1 is configured to receive a data signal Dm and supply a driving current to the light-emitting element ED according to a switching operation of the switching thin-film transistor T2.

A gate electrode of the switching thin-film transistor T2 is connected to the scan line SL, and a source electrode of the switching thin-film transistor T2 is connected to the data line DL. A drain electrode of the switching thin-film transistor T2 may be connected to the source electrode of the driving thin-film transistor T1, and simultaneously connected to the driving voltage line PL through the operation control thin-film transistor T5.

The switching thin-film transistor T2 is turned on according to a scan signal Sn transferred through the scan line SL and performs a switching operation of transferring a data voltage Dm to the source electrode of the driving thin-film transistor T1, wherein the data signal Dm is transferred to the data line DL.

A gate electrode of the compensation thin-film transistor T3 may be connected to the scan line SL. A source electrode of the compensation thin-film transistor T3 may be connected to the drain electrode of the driving thin-film transistor T1, and simultaneously, connected to the pixel electrode of the light-emitting element ED through the emission control thin-film transistor T6. A drain electrode of the compensation thin-film transistor T3 may be connected to one of electrodes of the storage capacitor Cst, a source electrode of the first initialization thin-film transistor T4, and the gate electrode of the driving thin-film transistor T1. The compensation thin-film transistor T3 may be turned on according to a scan signal Sn transferred through the scan line SL to diode-connect the driving thin-film transistor T1 by connecting the gate electrode to the drain electrode of the driving thin-film transistor T1.

A gate electrode of the first initialization transistor T4 may be connected to the previous scan line SL-1. A drain electrode of the first initialization transistor T4 may be connected to the initialization voltage line VL. A source electrode of the first initialization thin-film transistor T4 may be connected to one of the electrodes of the storage capacitor Cst, a drain electrode of the compensation thin-film transistor T3, and the gate electrode of the driving thin-film transistor T1. The first initialization thin-film transistor T4 may be turned on according to a previous scan signal Sn-1 received through the previous scan line SL-1 and may perform an initialization operation of initializing the voltage of the gate electrode of the driving thin-film transistor T1 by transferring an initialization voltage Vint to the gate electrode of the driving thin-film transistor T1.

A gate electrode of the operation control thin-film transistor T5 may be connected to the emission control line EL. A source electrode of the operation control thin-film transistor T5 may be connected to the driving voltage line PL. A drain electrode of the operation control thin-film transistor T5 is connected to the source electrode of the driving thin-film transistor T1 and the drain electrode of the switching thin-film transistor T2.

A gate electrode of the emission control thin-film transistor T6 may be connected to the emission control line EL. A source electrode of the emission control thin-film transistor T6 may be connected to the drain electrode of the driving thin-film transistor T1 and the source electrode of the compensation thin-film transistor T3. A drain electrode of the emission control thin-film transistor T6 may be electrically connected to the pixel electrode of the light-emitting element ED. The operation control thin-film transistor T5 and the emission control thin-film transistor T6 are simultaneously turned on according to an emission control signal En transferred through the emission control line EL, and the driving voltage ELVDD is transferred to the light-emitting element ED, and thus, the driving current flows through the light-emitting element ED.

A gate electrode of the second initialization thin-film transistor T7 may be connected to the next scan line SL+1. A source electrode of the second initialization thin-film transistor T7 may be connected to the pixel electrode of the light-emitting element ED. A drain electrode of the second initialization thin-film transistor T7 may be connected to the initialization voltage line VL. The second initialization thin-film transistor T7 may be turned on according to a next scan signal Sn+1 transferred through the next scan line SL+1 and may initialize the pixel electrode of the light-emitting element ED.

Although it is shown in FIG. 4 that the first initialization thin-film transistor T4 and the second initialization thin-film transistor T7 are respectively connected to the previous scan line SL-1 and the next scan line SL+1, the embodiment is not limited thereto. In another embodiment, both the first initialization thin-film transistor T4 and the second initialization thin-film transistor T7 may be connected to the previous scan line SL-1 and thus driven according to a previous scan signal Sn-1.

The other electrode of the storage capacitor Cst may be connected to the driving voltage line PL. One of the electrodes of the storage capacitor Cst may be connected to the gate electrode of the driving thin-film transistor T1, the drain electrode of the compensation thin-film transistor T3, and the source electrode of the first initialization thin-film transistor T4.

An opposite electrode (e.g., a cathode) of the light-emitting element ED is configured to receive a common voltage ELVSS. The light-emitting element ED may be configured to emit light by receiving the driving current from the driving thin-film transistor T1.

The pixel circuit PC is not limited to the number of thin-film transistors, the number of storage capacitors, and the circuit design described with reference to FIGS. 3 and 4 and the number of thin-film transistors, the number of storage capacitors, and the circuit design may be variously changed.

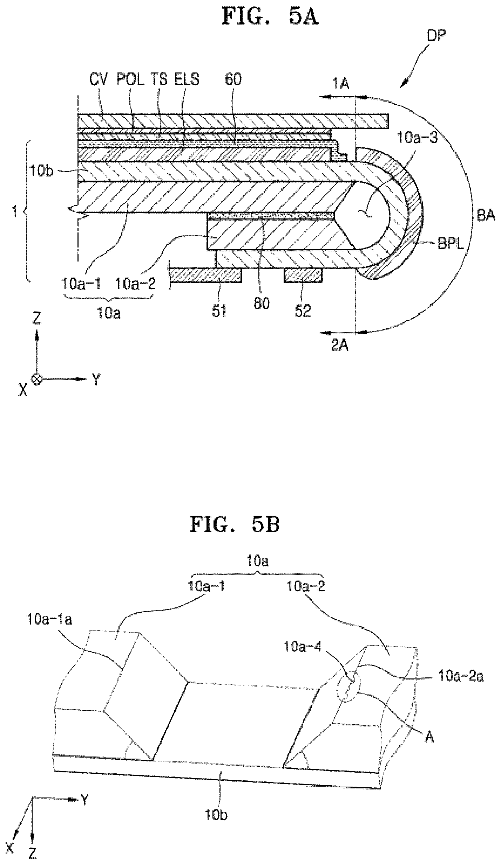

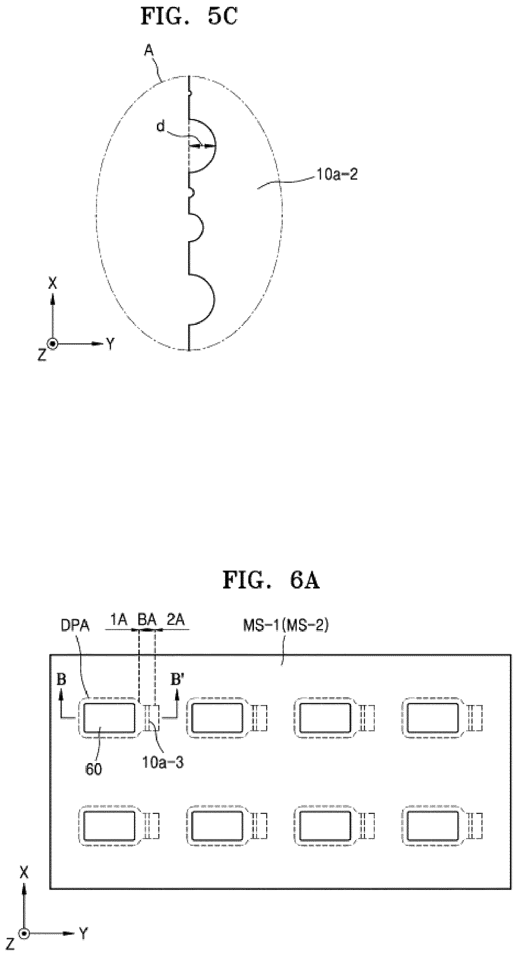

FIG. 5A is a schematic cross-sectional view of the display apparatus DP according to an embodiment. FIG. 5B is a schematic perspective view of the support substrate and the substrate shown in FIG. 5A. FIG. 5C is an enlarged backside view of a region A of FIG. 5B.

Referring to FIGS. 5A to 5C, the display apparatus DP may include the display panel 1, an optical functional layer POL, and a cover member CV. In this case, the display panel 1 may include a touch electrode layer TS disposed on the thin-film encapsulation layer 60. The touch electrode layer TS may include an electrode pattern and be disposed on the thin-film encapsulation layer 60 in the form a panel, or may have a form in which an electrode pattern is stacked on the thin-film encapsulation layer 60. The touch electrode layer TS may obtain coordinate information corresponding to an external input, for example, a touch event.

The optical functional layer POL may reduce the reflectivity of light (external light) incident toward the display apparatus DP from outside, and/or improve the color purity of light emitted from the display apparatus DP. In an embodiment, the optical functional layer POL may include a retarder and/or a polarizer. The retarder may include a film-type retarder or a liquid crystal-type retarder. The retarder may include a $\lambda/2$ retarder and/or a $\lambda/4$ retarder. The polarizer may include a film-type polarizer or a liquid crystal-type polarizer. The film-type polarizer may include a stretchable synthetic resin film, and the liquid crystal-type polarizer may include liquid crystals arranged in a predetermined arrangement. Each of the retarder and the polarizer may further include a protective film.

In another embodiment, optical functional layer POL may include a black matrix and color filters. The color filters may be arranged by taking into account colors of pieces of light emitted respectively from the pixels of the display panel 1. The color filters may each include red, green, or blue pigment or dye. Alternatively, the color filters may each further include quantum dots in addition to the pigment or dye. Alternatively, some of the color filters may not include pigment or dye, and may include particles (e.g., scatterers) such as titanium oxide.

In another embodiment, the optical functional layer POL may include a destructive interference structure. The destructive interference structure may include a first reflection layer and a second reflection layer respectively disposed on different layers. First-reflected light and second-reflected light respectively reflected by the first reflection layer and the second reflection layer may destructively interfere and thus the reflectivity of external light may be reduced.

An adhesive member may be disposed between the touch electrode layer TS and the optical functional layer POL. For the adhesive member, a general adhesive member known in the art may be employed without limitation. The adhesive member may be a pressure sensitive adhesive (PSA).

The cover member CV may be ultra-thin glass (UTG™) or colorless polyimide (CPI). In this case, the optical functional layer POL may be disposed on or under the cover member CV. Hereinafter, for convenience of description, the case where the optical functional layer POL is disposed under the cover member CV is mainly described in detail.

A portion of the display panel 1 may be bent to overlap another portion of the display panel 1. As an example, a portion of the display panel 1 corresponding to the substrate 10b arranged in the bent area BA may be bent. In this case, portions of the substrate 10b respectively arranged in the first area 1A, the bent area BA, and the second area 2A may be integrally formed.

The support substrate 10a disposed under the substrate 10b may include a first support substrate 10a-1 and a second support substrate 10a-2 that are apart from each other. In this case, the first support substrate 10a-1 may be separated from the second support substrate 10a-2 around an opening area 10a-3. In this case, a portion of the substrate 10b may be exposed to the outside in the opening area 10a-3. In this case, in a plan view, a planar shape of the opening area 10a-3 may be arranged inside the bent area BA or be the same as the bent area BA.

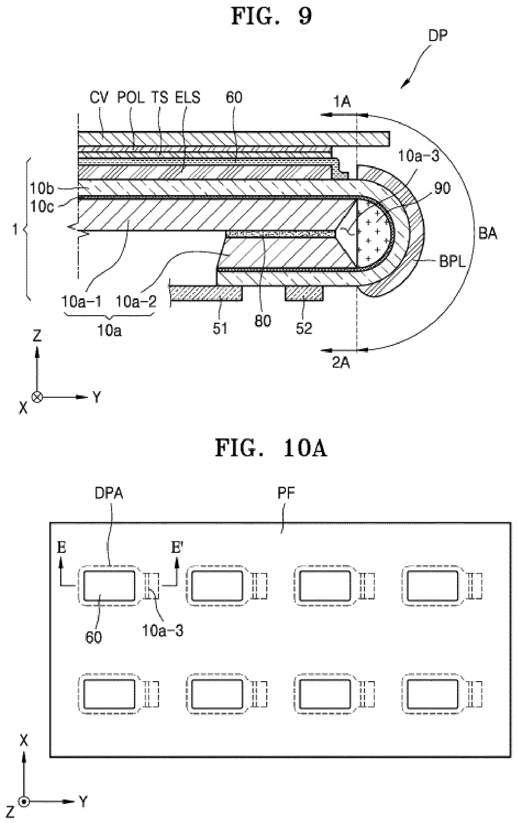

Although not shown, a protective layer (not shown) may be further disposed between the substrate 10b and the support substrate 10a. In this case, the protective layer may be disposed at the same position as the position shown in FIG. 9. In this case, the protective layer may include an organic layer configured to absorb vibrations transferred from the cutting unit PU while the cutting unit PU is used. A protective layer 10c(e.g., see FIG. 9) may include polyimide (PI) or polyamide (PA).

In the case where the display panel 1 is bent, an adhesive member 80 may be disposed on the second support substrate 10a-2. In this case, because the first support substrate 10a-1 serves to protect the substrate 10b disposed on the first support substrate 10a-1, the first support substrate 10a-1may have strength itself. In addition, the second support substrate 10a-2 may serve to protect the substrate 10b disposed under the second support substrate 10a-2.

One side of at least one of the first support substrate 10a-1 and the second support substrate 10a-2 may include a slope surface. As an example, one side adjacent to the opening area 10a-3 among at least one side of the first support substrate 10a-1 and the second support substrate 10a-2 may be a slope surface. Hereinafter, for convenience of description, the case where one side of the first support substrate 10a-1 and one side of the second support substrate 10a-2 adjacent to the opening area 10a-3 slope is mainly described in detail.

The one side of the first support substrate 10a-1 and the one side of the second support substrate 10a-2 may be slope surfaces that rise in a direction away from the opening area 10a-3. In this case, referring to FIG. 5A, the thickness of the cross-section of one side of the first support substrate 10a-1 and the thickness of the cross-section of one side of the second support substrate 10a-2 may increase as a distance from the opening are 10a-3 increases.

In this case, a groove 10a-4 may be formed in at least one of a slope surface of the first supporting substrate 10a-1 and a slope surface of the second supporting substrate 10a-2 and in at least one of boundaries (or edges), which are formed between the slope surface of the first supporting substrate 10a-1 and another surface of the first supporting substrate 10a-1 and the slope surface of the second supporting substrate 10a-2 and another surface of the second supporting substrate 10a-2. In an embodiment, one of the surface of the first support substrate 10a-1 and the surface of the second support substrate 10a-2 facing each other may include a groove 10a-4 extending in a direction away from another one of the surface of the first support substrate 10a-1 and the surface of the second support substrate 10a-2 facing each other. As an example, the groove 10a-4 may be formed in an edge 10a-1a between a side of the first support substrate 10a-1 facing the second support substrate 10a-2 and a slope surface of the first support substrate 10a-1. In another embodiment, the groove 10a-4 may be formed in an edge 10a-2a between a side of the second support substrate 10a-2 facing the first support substrate 10a-1 and a slope surface of the second support substrate 10a-2. In another embodiment, the groove 10a-4 may be formed in an edge between a side of the first support substrate 10a-1 facing the substrate 10b and a slope surface of the first support substrate 10a-1. In addition, the groove 10a-4 may be formed in an edge 10a-2a between a surface of the second support substrate 10a-2 facing the substrate 10b and a slope surface of the second support substrate 10a-2. In another embodiment, the groove 10a-4 may be formed in at least one of a slope surface of the first support substrate 10a-1 and a slope surface of the second support substrate 10a-2. In this case, though not shown, the groove 10a-4 may extend to a slope surface of the first support substrate 10a-1a from the edge between one side of the first support substrate 10a-1 and the slope surface of the first support substrate 10a-1, and extend to an edge between the slope surface of the first support substrate 10a-1 and another side of the first support substrate 10a-1. In this case, the slope surface of the first support substrate 10a-1 may connect one side of the first support substrate 10a-1 and another side of the first support substrate 10a-1 facing each other. Hereinafter, for convenience of description, the case where the groove 10a-4 is formed between one side of the first support substrate 10a-1 and the slope surface of the first support substrate 10a-1 is mainly described in detail.

A maximum width of the groove 10a-4 may be greater than 0 $\mu$m and may be equal to or less than 50 $\mu$m. For example, A a maximum width d of the groove 10a-4 measured in one direction (e.g., a Y axis direction of FIG. 5C) from the boundaries 10a-1a and 10a-2a where two sides meet each other, and one lower point of the side of the first support substrate 10a-1 or the side of the second support substrate 10a-2 may be in a range exceeding 0 $\mu$m and equal to or less than 50 $\mu$m.

Because at least one of the first support substrate 10a-1 and the second support substrate 10a-2 adjacent to the opening area 10a-3 includes a slope surface, when the substrate 10b is bent in the bent area BA, a slope surface of the support substrate 10a may be bent together or may vary in shape. In addition, even when force is applied to the bent area BA after the substrate 10b is bent, the force applied to the bent area BA may be supported through the slope surface of the support substrate 10a.

Although embodiments show that the substrate 10b is bent around the bending axis such that a portion of the lower surface in the first area 1A faces a portion of the lower surface in the second area 2A, the embodiment is not limited thereto. As an example, a curvature in the bent area BA may be less than a curvature shown in the drawings, or even when a curvature does not drastically change in the bent area BA, the area of the bent area BA is narrow and a lower surface in the second area 2A may not face a lower surface in the first area 1A. However, various changes may be made.

The first support substrate 10a-1 arranged in bent one side of the substrate 10b may face the second support substrate 10a-2.

In this case, the display area DA shown in FIG. 1 may be arranged in the first support substrate 10a-1. In this case, in a plan view, the edge (or the boundary) of the display area DA may be arranged inside the edge (or the boundary) of the first support substrate 10a-1. In a plan view, the size of a planar shape of the first support substrate 10a-1 may be greater than the size of a planar shape of the second support substrate 10a-2.

In this case, in a plan view, at least a portion of the second support substrate 10a-2 may overlap the display area DA shown in FIG. 1. As an example, in a plan view, at least a portion of the second support substrate 10a-2 may be arranged inside the display area DA. In this case, in a plan view, at least a portion of the edge (or the boundary) of the second support substrate 10a-2 may be arranged inside the edge (or the boundary) of the display area DA.

In this case, the adhesive member 80 may be disposed on one side of the second support substrate 10a-2, and the adhesive member 80 may fix the second support substrate 10a-2 to the first support substrate 10a-1. In this case, one side of the second support substrate 10a-2 may be fixed to the first support substrate 10a-1 through the adhesive member 80, and another side of the second support substrate 10a-2 may be directly fixed to the substrate 10b without a separate adhesive member.

Though not shown in the drawing, a separate protective member may be disposed between the first support substrate 10a-1 and the second support substrate 10a-2. The protective member may include polymer resin such as polyurethane, polycarbonate, polypropylene, polyethylene, and the like, or rubber, urethane-based materials, epoxy-based materials, acrylic-based materials, or resins in combination thereof may be disposed and cured on the first support substrate 10a-1 and the second support substrate 10a-2 and fill the protective member. Alternatively, the protective member may be disposed in the form of a sheet including an elastic material such as sponge molded by foaming rubber, urethane-based materials, epoxy-based or acrylic-based materials.

The protective member may be disposed between the first support substrate 10a-1 and the second support substrate 10a-2 and may prevent the first support substrate 10a-1 from colliding with the second support substrate 10a-2.

The display panel 1 may include a bending protective layer BPL arranged in the bent portion or bent area BA. In this case, the bending protective layer BPL may be arranged in the bent area BA of the substrate 10b and may prevent the substrate 10b from being destroyed while the substrate 10b is bent. The bending protective layer BPL may include polymer resin such as polyethyleneterephthalate (PET) and polyimide (PI). The bending protective layer BPL may have a greater planar shape than the bent area BA shown in FIG. 1. That is, in a plan view, the bent area BA may be arranged inside the bending protective layer BPL. In addition, in a plan view, the opening area 10a-3 may be arranged inside the bending protective layer BPL.

Accordingly, the display apparatus DP may partially increase strength of the bent area BA.

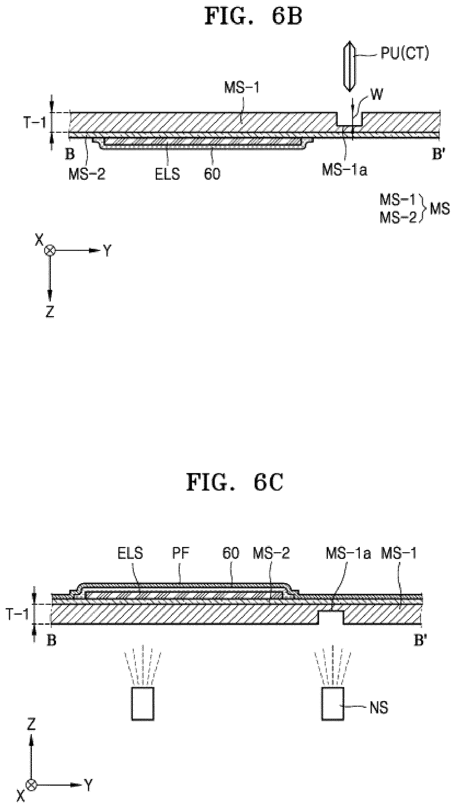

FIG. 6A is a schematic plan view showing manufacturing of the display apparatus DP according to an embodiment. FIG. 6B is a schematic cross-sectional view showing manufacturing of the display apparatus DP taken along line B-B' of FIG. 6A according to an embodiment.

Referring to FIGS. 6A and 6B, a first base substrate MS-1 is prepared, and then, a second base substrate MS-2, a display portion ELS, and the thin-film encapsulation layer 60 may be disposed or formed on the first base substrate MS-1. In this case, the first base substrate MS-1 may include the same material as a material of the support substrate 10a, and the second base substrate MS-2 may include the same material as a material of the substrate 10b. In this case, the second base substrate MS-2 may be disposed on the front surface of the first base substrate MS-1 or disposed on only a portion of the first base substrate MS-1. The first base substrate MS-1 may have a first thickness T-1. Hereinafter, for convenience of description, the case where the second base substrate MS-2 is disposed on the first base substrate MS-1 entirely is mainly described in detail.

At least one display portion ELS may be disposed on the second base substrate MS-2. In the case where a plurality of display portions ELS are provided, the plurality of display portions ELS may be disposed to be apart from each other on the second base substrate MS-2. In another embodiment, in the case where the substrate 10b is provided in plurality, the plurality of substrates 10b are disposed to be apart from each other. In this case, the display portion ELS may be provided in plurality, and each display portion ELS may be disposed on each substrate 10b. In this case, the thin-film encapsulation layer 60 may be disposed on each display portion ELS. In this case, the thin-film encapsulation layer 60 may be disposed to shield each display portion ELS completely and be disposed in plurality to be apart from each other. Each thin-film encapsulation layer 60 may be disposed to correspond to each display portion ELS. Hereinafter, for convenience of description, the case where one second base substrate MS-2 is disposed on the first base substrate MS-1, and each display portion ELS and each thin-film encapsulation layer 60 are disposed on the second base substrate MS-2 is mainly described in detail.

A reference groove MS-1a may be formed in the first base substrate MS-1. In this case, the reference groove MS-1a may be formed in a portion of a panel area DPA corresponding to the opening area 10a-3. In this case, in a plan view, a planar shape of the reference groove MS-1a may be arranged inside a planar shape of the opening area 10a-3.

The reference groove MS-1a may be formed by using a cutting unit PU. In this case, the cutting unit PU may include a cutter that physically forms the reference groove MS-1a, such as a blade, or a laser irradiator that forms the reference groove MS-1a by irradiating a laser beam. Hereinafter, for convenience of description, the case where the cutting unit PU includes a cutter is mainly described in detail.

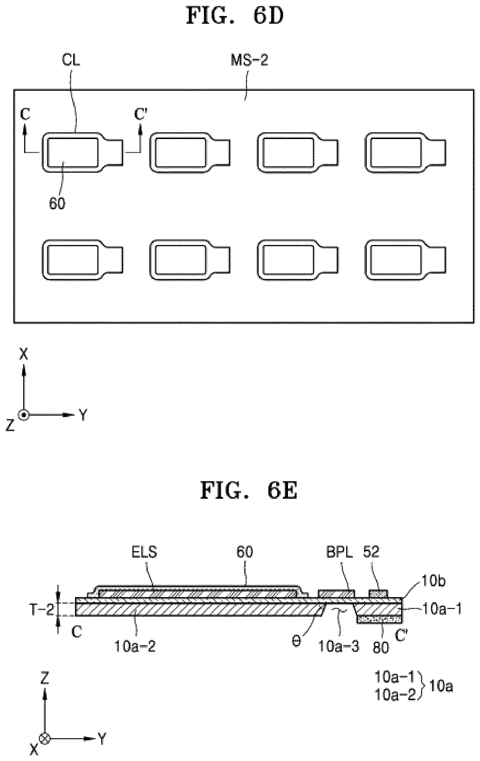

The reference groove MS-1a may have a depth w measured from one side of the first base substrate MS-1. In this case, the depth w may have linear relationship with a taper angle $\theta$ (see FIG. 6E) of a slope surface(e.g., a surface of the first base substrate MS-1 disposed around the opening area 10a-3). As an example, the depth w and the taper angle $\theta$ may have a relationship represented by Equation 1 below. In this case, the taper angle $\theta$ may denote an angle between one side of the first base substrate MS-1 contacting the second base substrate MS-2, and a slope surface of the first base substrate MS-1.

## [Equation 1]

$$Y = 0.1838X + 5.2766$$

Here, Y denotes the taper angle $\theta$, its unit is degree (°), X denotes the depth w, and its unit is micrometer ($\mu$m). In addition, the unit of 0.1838 may be °/$\mu$m, and the unit of 5.2766 may be °.

A groove may be formed in a portion of the reference groove MS-1a. As an example, a groove may be formed in an entry portion of the reference groove MS-1a formed in one side of the first base substrate MS-1 on which the second base substrate MS-2 is not disposed.

FIG 6C are schematic cross-sectional view showing manufacturing of the display apparatus DP taken along line B-B' of FIG. 6A according to an embodiment.

Referring to FIG. 6C, the reference groove MS-1a is formed, and then, a protective film PF may be disposed or attached on the display portion ELS and the thin-film encapsulation layer 60. In this case, the protective film PF may be attached to the entire surface of the first base substrate MS-1 or attached to only a portion of the first base substrate MS-1 on which the thin-film encapsulation layer 60 is disposed. The protective film PF may have heat resistance and chemical resistance.

In addition, an etching solution may be sprayed on one side of the first base substrate MS-1 on which the second base substrate MS-2 is not disposed, through a nozzle NS. The etching solution may reach the first base substrate MS-1 in the outside and etch one side of the first base substrate MS-1. Through this, one side of the first base substrate MS-1 may be isotropically etched, and the reference groove MS-1a may expand to form the opening 10a-3. In this case, one side of the first base substrate MS-1 adjacent to the opening area 10a-3 may be formed to be a slope surface. In this case, the groove may be formed in the boundary of the slope surface as shown in FIG. 5C. In another embodiment, the groove may be completely removed from the boundary of the slope surface.

FIG. 6D is a schematic plan view showing manufacturing of the display apparatus DP according to an embodiment. Referring to FIG. 6D, the first base substrate MS-1 and the second base substrate MS-2 may be separated in plurality through a cutting line CL. In an embodiment, the first base substrate MS-1 and the second base substrate MS-2 may be cut along a cutting line CL spaced apart from an edge portion of the display layer and the thin-film encapsulation layer 60. In this case, there may be various methods of separating the first base substrate MS-1 and the second base substrate MS-2 using the cutting line CL. In an embodiment, the first base substrate MS-1 and the second base substrate MS-2 may be separated into a plurality of display panels 1 by irradiating a laser beam to the first base substrate MS-1 and the second base substrate MS-2 along the cutting line CL or separating the first base substrate MS-1 and the second base substrate MS-2 through the cutter CT. In another embodiment, the second base substrate MS-2 may be separated into a plurality of pieces through the cutter CT, and then, a separate protective film is attached to the inside of the cutting line CL of the first base substrate MS-1, and then, the first base substrate MS-1 may be separated into a plurality of pieces along the cutting line CL through etching. In this case, as described above, the method of separating the first base substrate MS-1 may be performed separately from or simultaneously with the process shown in FIGS. 6B and 6C.

In the case where the first base substrate MS-1 and the second base substrate MS-2 are separated along the cutting line CL, the first base substrate MS-1 may be divided into a plurality of pieces to form one display panel 1. In this case, the display panel 1 may include the substrate 10b, and the first support substrate 10a-1 and the second support substrate 10a-2 may be disposed under the substrate 10b, wherein the first support substrate 10a-1 is separated from the second support substrate 10a-2 by the opening area 10a-3.

FIG. 6E is a schematic cross-sectional view showing manufacturing of the display apparatus DP taken along line C-C' of FIG. 6D according to an embodiment.

Referring to FIG. 6E, the adhesive member 80 may be disposed on the second support substrate 10a-2. Then, the second support substrate 10a-2 may be attached to the first support substrate 10a-1 using the adhesive member 80 by bending a portion of the substrate 10b on which the second support substrate 10a-2 is disposed.

The thickness of the support substrate 10a may be a second thickness T-2. In this case, the second thickness T-2 may be less than the first thickness T-1 described above.

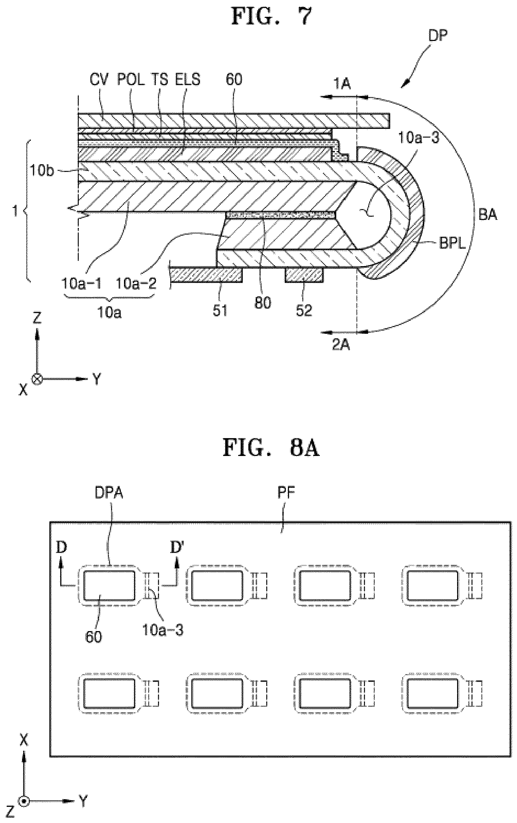

FIG. 7 is a schematic cross-sectional view of the display apparatus DP according to another embodiment. Hereinafter, the same reference numerals as those of FIG. 5A represent the same members.

Referring to FIG. 7, the display apparatus DP may include the display panel 1, the display circuit board 51, the display driver 52, the touch sensor driver (not shown), the optical functional layer POL, and the cover member CV. In this case, the display panel 1 may include the support substrate 10a, the substrate 10b, the display portion ELS, and the touch electrode layer TS disposed on the thin-film encapsulation layer 60. In this case, because the display panel 1 is the same as or similar to that described with reference to FIGS. 1, 2 and 5A to 5C, detailed description is omitted.

The support substrate 10a may include the first support substrate 10a-1 and the second support substrate 10a-2 arranged to be apart from each other around the opening area 10a-3. In this case, one side of the first support substrate 10a-1 and one side of the second support substrate 10a-2 adjacent to the opening area 10a-3 may be slope surfaces.

At least one of surfaces forming the edge of the first support substrate 10a-1 may be a slope surface. In addition, at least one of surfaces forming the edge of the second support substrate 10a-2 may be a slope surface. As an example, at least one of two opposite sides (e.g., sides arrange in long sides of the first support substrate 10a-1) arranged in an X axis direction of the first support substrate 10a-1 and two opposite sides (e.g., sides arrange in short sides of the first support substrate 10a-1) arranged in a Y axis direction of the first support substrate 10a-1 arranged in the first area 1A in FIG. 1 may be a slope surface. In this case, one of the two opposite sides arranged in the short sides of the first support substrate 10a-1 may be a surface adjacent to the opening area 10a-3. In addition, at least one of two opposite sides (e.g., sides arrange in short sides of the second support substrate 10a-2) arranged in an X axis direction of the second support substrate 10a-2 and two opposite sides (e.g., sides arrange in long sides of the second support substrate 10a-2) arranged in a Y axis direction of the second support substrate 10a-2 arranged in the second area 2A may be a slope surface. In this case, one of the two opposite sides arranged in the short sides of the second support substrate 10a-2 may be a surface adjacent to the opening area 10a-3. Hereinafter, for convenience of description, the case where the side arranged in the long side of the second support substrate 10a-2 is a slope surface is mainly described in detail.

In this case, two opposite sides arranged in the long sides of the second support substrate 10a-2 may be slope surfaces. In addition, in this case, the groove (not shown) described above may be formed in the boundary between one of the two opposite sides arranged in the long sides of the second support substrate 10a-2, and one side of the second support substrate 10a-2 on which the adhesive member 80 is disposed.

Accordingly, the display apparatus DP may partially increase strength of the bent area BA.

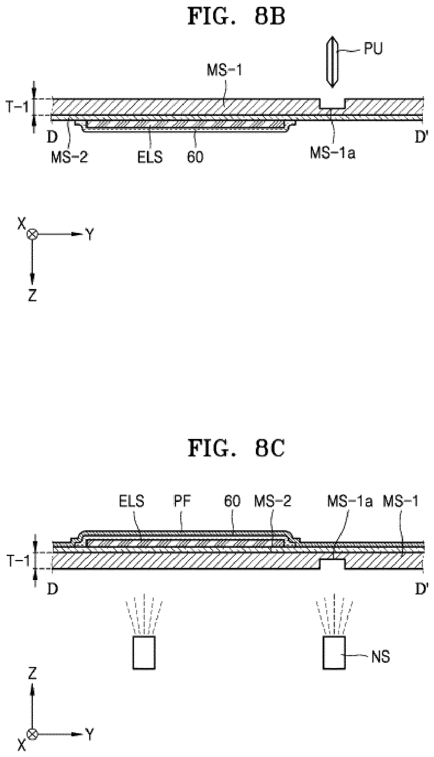

FIG. 8A is a schematic plan view showing manufacturing of the display apparatus DP taken along line D-D' of FIG. 8A according to another embodiment. FIG. 8B is a schematic cross-sectional view showing manufacturing of the display apparatus DP according to another embodiment. Referring to FIGS. 8A and 8B, the second base substrate MS-2 may be disposed on the entire surface of the first base substrate MS-1, or a plurality of substrates 10b arranged to be apart from each other may be formed. In this case, each substrate 10b may be arranged to correspond to the panel area DPA. The panel areas DPA may be separated from each other afterward and may each form one display panel 1.

Hereinafter, for convenience of description, the case where the second base substrate MS-2 is disposed on the entire surface of the first base substrate MS-1 is mainly described in detail.

The display portion ELS and the thin-film encapsulation layer 60 may be disposed on the second base substrate MS-2, and then, the reference groove MS-1a may be formed in the first base substrate MS-1 using the cutting unit PU. In this case, the reference groove MS-1a may be formed in one side of the first base substrate MS-1 on which the display portion ELS is not disposed. The thickness of the first base substrate MS-1 may be the first thickness T-1.

FIG. 8C is a schematic cross-sectional view showing manufacturing of the display apparatus DP taken along line D-D' of FIG. 8A according to another embodiment.

Referring to FIG. 8C, the protective film PF may be disposed on the thin-film encapsulation layer 60. In this case, because the protective film PF is the same as or similar to that described with reference to FIG. 6C, detailed description thereof is omitted.

An etching solution may be sprayed to entire one side of the first base substrate MS-1 in which the reference groove MS-1a is formed, through the nozzle NS. In this case, the etching solution may be configured to isotropically etch entire one surface of the first base substrate MS-1. In this case, the etching solution may expand the reference groove MS-1a, and the opening area 10a-3 may be formed in the first base substrate MS-1.

In this case, in the case where the etching solution is sprayed, the size of the opening area 10a-3 may be formed less than a designed size.

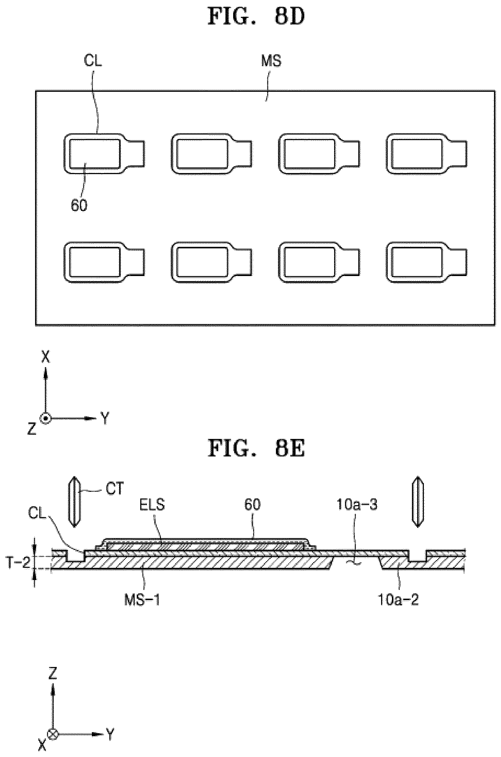

In the case where the etching solution is sprayed to the first base substrate MS-1, the thickness of the first base substrate MS-1 may be a second thickness T-2 as shown in FIG. 8E. In this case, the second thickness T-2 may be less than the first thickness T-1.

FIG. 8D is a schematic plan view showing manufacturing of the display apparatus DP according to another embodiment. FIG. 8E is a schematic cross-sectional view showing manufacturing of the display apparatus DP according to another embodiment.

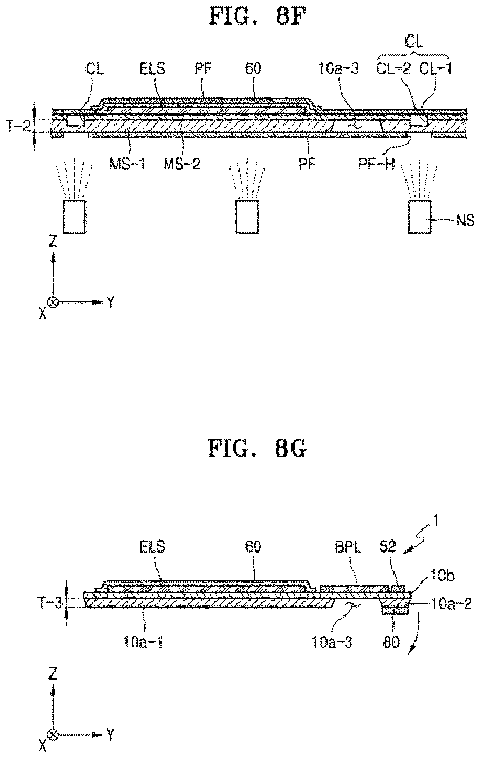

Referring to FIGS. 8D and 8E, the cutting line CL may be formed in the second base substrate MS-2 and the first base substrate MS-1. In this case, the cutting line CL may be formed using the cutter CT. In this case, a cutting groove or cutting line hole CL-1(e.g., see FIG. 8F) may be formed in the second base substrate MS-2, and a cutting line hole CL-2(e.g., see FIG. 8F) may be formed in the first base substrate MS-1. In this case, the cutting line hole CL-1 may be connected to the cutting line groove CL-2.

In this case, the cutter CT may be configured to cut the first base substrate MS-1 and the second base substrate MS-2 along the cutting line CL instead of forming the cutting line hole CL-1 and the cutting line groove CL-2. In this case, the display panel 1 may be separated from the first base substrate MS-1 and the second base substrate MS-2 and the process may be finished.

Hereinafter, for convenience of description, the case where the cutter CT is configured to form the cutting line hole CL-1 and the cutting line groove CL-2 is mainly described in detail.

FIG. 8F is a schematic cross-sectional view showing manufacturing of the display apparatus DP according to another embodiment.

Referring to FIG. 8F, the cutting line CL is formed, and then, the protective film PF may be disposed on the thin-film encapsulation layer 60. In this case, the protective film PF may be the same as or similar to that described above.

A protective film hole (not shown) of the protective film PF may be formed to correspond to the cutting line CL. In another embodiment, the protective film PF may be disposed to cover the cutting line CL. Hereinafter, for convenience of description, the case where the protective film PF is disposed to cover the cutting line CL is mainly described in detail.

The protective film PF may be disposed on one side of the first base substrate MS-1 in which the opening area 10a-3 is arranged. In this case, a protective film hole PF-H may be formed in a portion of the protective film PF corresponding to the cutting line CL.

When the above process is completed, an etching solution may be sprayed to one side of the first base substrate MS-1 on which the display portion ELS is not disposed, through the nozzle NS. In the case, because the etching solution etches one side of the first base substrate MS-1, a hole connected to the cutting line CL may be formed.

In this case, though not shown in the drawing, a separate protective film may not be disposed on an entire one side of the first support substrate 10a-1 on which the display portion ELS is not disposed except for the cutting line CL.

FIG. 8G is a schematic cross-sectional view showing manufacturing of the display apparatus DP according to another embodiment.

Referring to FIG. 8G, one display panel 1 may be separated from the first base substrate MS-1 and the second base substrate MS-2 through the cutting line CL. In this case, at least one of sides of the second support substrate 10a-2 of the display panel 1 may slope. In this case, a slope direction of a side of the second support substrate 10a-2 adjacent to the opening area 10a-3 may be opposite to a slope direction of another side. As an example, referring to the cross-section of FIG. 8G, a side of the second support substrate 10a-2 adjacent to the opening area 10a-3 may lower toward the right from the left, while a side of the second support substrate 10a-2 disposed on the end may lower toward the left from the right.

FIG. 9 is a schematic cross-sectional view of the display apparatus DP according to another embodiment. Hereinafter, the same reference numerals as those of FIG. 5A represent the same members.

Referring to FIG. 9, the display apparatus DP may include the display panel 1, the display circuit board 51, the display driver 52, the touch sensor driver (not shown), the optical functional layer POL, and the cover member CV. In this case, the display panel 1 may include the support substrate 10a, the substrate 10b, the display portion ELS, and the touch electrode layer TS disposed on the thin-film encapsulation layer 60. In this case, because the display panel 1 is similar to that described with reference to FIGS. 1, 2 and 5A to 5C, detailed description is omitted.

The display panel 1 may include the protective layer 10c disposed between the support substrate 10a and the substrate 10b. In the case where a laser beam is irradiated, the protective layer 10c may reduce transfer of the laser beam to the display portion ELS or reduce transfer of heat generated by the laser beam to the display portion ELS. The protective layer 10c may include an inorganic layer. As an example, the protective layer 10c may include amorphous silicon, silicon oxide ($SiO_x$) and/or silicon nitride ($SiN_x$).

In a plan view, the protective layer 10c may be arranged to overlap at least a portion of the substrate 10b. Hereinafter, for convenience of description, the case where the protective layer 10c is disposed on the entire surface of the substrate 10b is mainly described in detail.

In addition, the display panel 1 may include a filler 90 arranged in the bent area of the substrate 10b. In this case, the filler 90 may include an elastic material and maintain bending of the substrate 10b while the substrate 10b is bent. In addition, in the case where external force is applied to the bent area, the filler 90 may prevent the substrate 10b in the bent area from being destroyed by absorbing impacts. In this case, the filler 90 may be disposed to fill at least a portion of a space formed by the first support substrate 10a-1, the second support substrate 10a-2, the adhesive member 80, and the substrate 10b.

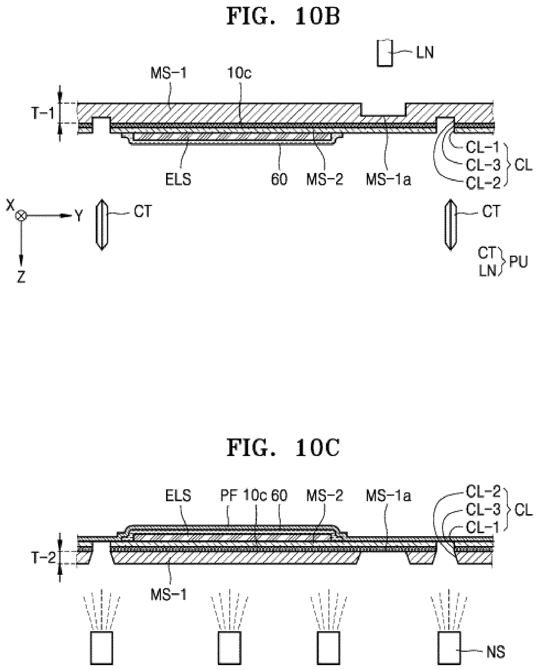

FIG. 10A is a schematic plan view showing manufacturing of the display apparatus DP according to another embodiment. FIG. 10B is a schematic cross-sectional view showing manufacturing of the display apparatus DP taken along line E-E' of FIG. 10A according to another embodiment.

Referring to FIGS. 10A and 10B, the first base substrate MS-1, the protective layer 10c, and the second base substrate MS-2 are sequentially stacked, and then, the display portion ELS and the thin-film encapsulation layer 60 may be disposed on the second base substrate MS-2.

Then, the reference groove MS-1a and the cutting line CL may be formed. In this case, the reference groove MS-1a and the cutting line CL may be formed using a cutter or a laser irradiator LN. In this case, in the case where the cutting line CL is formed using the laser irradiator LN, the protective layer 10c may not be arranged in a portion in which the cutting line CL is formed. That is, because the protective layer 10c is arranged in only the panel area DPA, a plurality of protective layers 10c may be arranged to be apart from each other like the panel areas DPA. In another embodiment, in the case where the cutting line CL is formed using the cutter CT, the protective layer 10c may be formed on the entire surface of the first base substrate MS-1. Hereinafter, for convenience of description, the case where the protective layer 10c is formed on the entire surface of the first base substrate MS-1 and the cutting unit PU includes the cutter CT is mainly described in detail.

The thickness of the first base substrate MS-1 may be the first thickness T-1.

FIG. 10C is a schematic cross-sectional view showing manufacturing of the display apparatus DP taken along line E-E' of FIG. 10A according to another embodiment.

Referring to FIG. 10C, the cutting line CL and the reference groove MS-1a are formed, and then, the protective film PF may be disposed on the second base substrate MS-2 on which the cutting line CL is disposed. In this case, the protective film PF may be disposed on the entire surface of the first base substrate MS-1 to cover the cutting line CL.

Then, an etching solution may be sprayed to one side of the first base substrate MS-1 on which the second base substrate MS-2 is not disposed, through the nozzle NS. In this case, one side of the first base substrate MS-1 may be etched, and the reference groove MS-1a may expand to form the opening 10a-3. In addition, because a portion of the first base substrate MS-1 on which the cutting line CL is disposed is etched and connected to the cutting line CL, the panel area DPA (see FIG. 10A) may be separated from the first base substrate MS-1 and the second base substrate MS-2. In this case, a portion of the outer surface of the display panel 1 cut along the cutting line CL may slope, and a portion of the outer surface may be a straight line. In addition, the thickness of the first base substrate MS-1 may be the second thickness T-2. In this case, the second thickness T-2 may be less than the first thickness T-1.

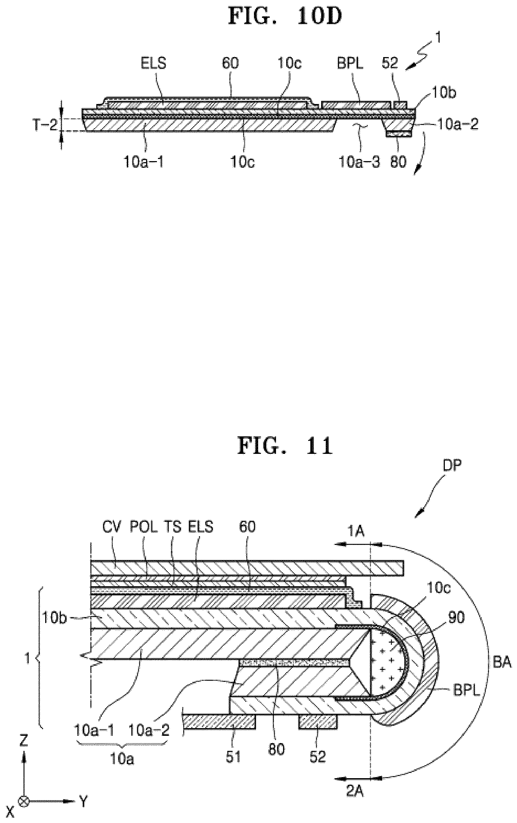

FIG. 10D is a schematic cross-sectional view showing manufacturing of the display apparatus DP taken along line E-E' of FIG. 10A according to another embodiment.

Referring to FIG. 10D, the display panel 1 separated from the first base substrate MS-1 and the second base substrate MS-2 may be bent. In this case, the adhesive member 80 is disposed on the second support substrate 10a-2, and then, the first support substrate 10a-1 may be attached to the second support substrate 10a-2 by bending the bent area of the substrate 10b. In this case, the adhesive member 80 may be attached to the first support substrate 10a-1 first, and then attached to the second support substrate 10a-2. In this case, the bending protective layer BPL may be arranged in the bent area, and the display driver 52 may be arranged in the second area 2A. In an embodiment, the second base substrate MS-2 may be bent around an arbitrary bending axis overlapping the bending protective layer BPL.

FIG. 11 is a schematic cross-sectional view of the display apparatus DP according to another embodiment. Hereinafter, the same reference numerals as those of FIG. 5A represent the same members.

Referring to FIG. 11, the display apparatus DP may include the display panel 1, the display circuit board 51, the display driver 52, the touch sensor driver (not shown), the optical functional layer POL, and the cover member CV. In this case, the display panel 1 may include the support substrate 10a, the substrate 10b, the display portion ELS, and the touch electrode layer TS disposed on the thin-film encapsulation layer 60. In this case, because the display apparatus DP and the display panel 1 are similar to those described with reference to FIGS. 1, 2 and 5A to 5C, detailed descriptions thereof are omitted.

The display panel 1 may include the protective layer 10c disposed between the support substrate 10a and the substrate 10b. In this case, the protective layer 10c may be disposed on only a portion of the substrate 10b. As an example, in a plan view, the protective layer 10c may be arranged to overlap the bent area BA. In this case, in a plan view, the reference groove (not shown) may be formed inside the protective layer 10c in FIGS. 10B, and 10C.

The protective layer 10c may prevent the display portion ELS arranged around the reference groove from being damaged while the reference groove is formed through the laser beam.

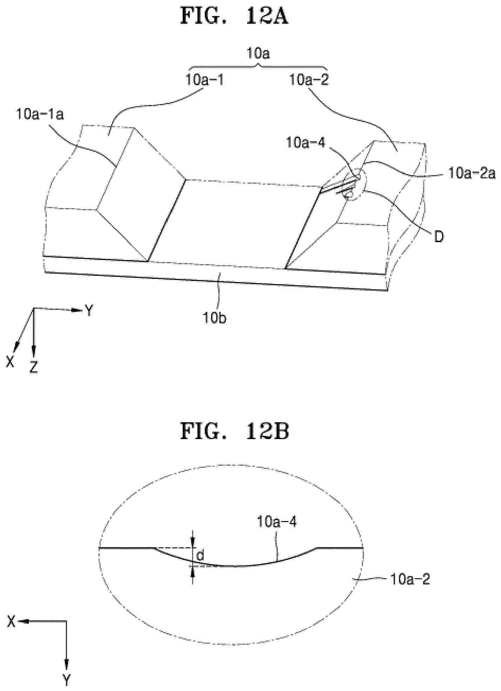

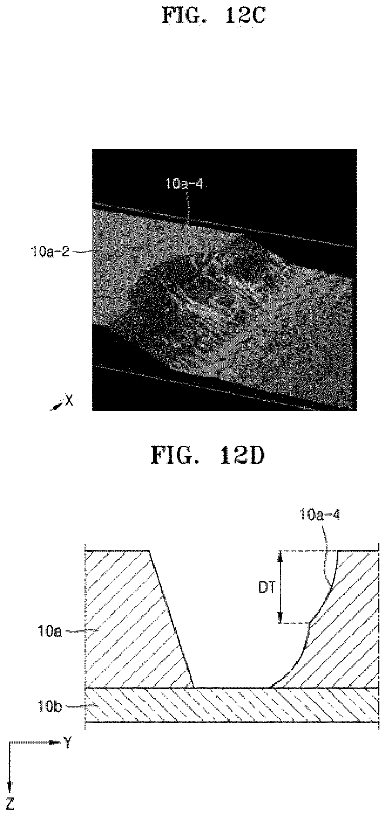

FIG. 12A is a schematic perspective view of a portion of a display apparatus according to another embodiment, FIG. 12B is an enlarged backside view of a region D of FIG. 12A, FIG. 12C is a perspective view of a portion shown in FIG. 12A, and FIG. 12D is a cross-sectional view of an opening area shown in FIG. 12A.

Referring to FIG. 12A, the display apparatus DP may include a display panel (not shown), a display circuit board (not shown), a display driver (not shown), a touch sensor driver (not shown), an optical functional layer (not shown), and a cover member (not shown). In this case, the display panel may include the support substrate 10b, the substrate 10a, a display portion (not shown), a touch electrode layer (not shown) disposed on a thin-film encapsulation layer (not shown). In this case, because the display apparatus and the display panel are similar to those described with reference to FIGS. 1, 2, and 5A to 5C, detailed descriptions thereof are omitted.

In addition, the support substrate 10a may include the first support substrate 10a-1 and the second support substrate 10a-2. In this case, because the first support substrate 10a-1 and the second support substrate 10a-2 are the same as or similar to those described with reference to FIGS. 1, 2, and 5A to 5C, detailed descriptions thereof are omitted.

At least one of the slope surface of the first support substrate 10a-1 and the slope surface of the second support substrate 10a-2 may include the groove 10a-4. The groove 10a-4 may be disposed in at least one of a boundary 10a-1a between a slope surface of the first support substrate 10a-1 and one surface of the first support substrate 10a-1, and a boundary 10a-2a between a slope surface of the second support substrate 10a-2 and one surface of the second support substrate 10a-2. Because the case where the groove 10a-4 is formed in the slope surface of the first support substrate 10a-1 and the case where the groove 10a-4 is formed in the slope surface of the second support substrate 10a-2 are similar to each other, the case where the groove 10a-4 is formed in the slope surface of the first support substrate 10a-1 is mainly described below in detail, for convenience of description.

In the case where the groove 10a-4 is disposed in the boundary 10a-1a between the slope surface of the first support substrate 10a-1 and one surface of the first support substrate 10a-1, the groove 10a-4 may extend to the slope surface of the first support substrate 10a-1. In this case, the groove 10a-4 may be disposed in only a portion of the slope surface of the first support substrate 10a-1, or may extend from one of the boundaries of the slope surface of the first support substrate 10a-1 to another of the boundaries of the slope surface of the first support substrate 10a-1. In addition, the groove 10a-4 may be formed in a line shape in the slope surface of the first support substrate 10a-1. That is, the width of the groove 10a-4 may be constant in a lengthwise direction of the groove 10a-4. In another embodiment, the width of the groove 10a-4 may vary in the slope surface of the first support substrate 10a-1. In this case, the width of the groove 10a-4 may be reduced in the lengthwise direction of the groove 10a-4 in the slope surface of the first support substrate 10a-1. That is, the width of the groove 10a-4 may be reduced toward the substrate 10b from one surface of the first support substrate 10a-1. In another embodiment, the groove 10a-4 may be a portion of a sphere. Alternatively, the groove 10a-4 may have an ellipsoidal shape. In another embodiment, the groove 10a-4 may have an irregular shape. Hereinafter, for convenience of description, the case where the groove 10a-4 is a portion of a sphere is mainly described in detail.

Referring to FIGS. 12C and 12D, a cross-section (e.g., a cross-section taken along a Z-Y plane in FIG. 12A) of one surface of the support substrate defining the groove 10a-4 may be round. In this case, the cross-section of one surface of the support substrate defining the groove 10a-4 may be formed in various shapes. In an embodiment, the cross-section of one surface of the support substrate defining the groove 10a-4 may have one round shape. In another embodiment, the cross-section of one surface of the support substrate defining the groove 10a-4 may be formed to have a step difference in a thickness direction of the support substrate 10a. In this case, the cross-section of one surface of the support substrate defining the groove 10a-4 may have at least two different surfaces. As an example, the cross-section of one surface of the support substrate defining the groove 10a-4 is variable in its shape with respect to one surface of the support substrate 10a around one point. In this case, around one point of the cross-section of the surface of the groove 10a-4, slope surfaces of two opposite sides of the cross-section of one surface of the support substrate defining the groove 10a-4 may be connected to each other while having different shapes. At least one point where the shape is variable may be provided on the cross section of one surface of the support substrate defining the groove 10a-4. In another embodiment, the cross section of one surface of the support substrate defining the groove 10a-4 may include a plurality of irregularities. That is, the cross-section of the surface of the groove 10a-4 may have an uneven shape.

The groove 10a-4 formed in the boundary 10a-1a between the slope surface of the first support substrate 10a-1 and one surface of the first support substrate 10a-1 may have a preset depth DT from the one surface of the first support substrate 10a-1. In this case, the depth DT of the groove 10a-4 may be proportional to a maximum width d of the groove 10a-4 formed in one surface of the first support substrate 10a-1. That is, when the maximum width d of the groove 10a-4 increases, the depth DT may increase.

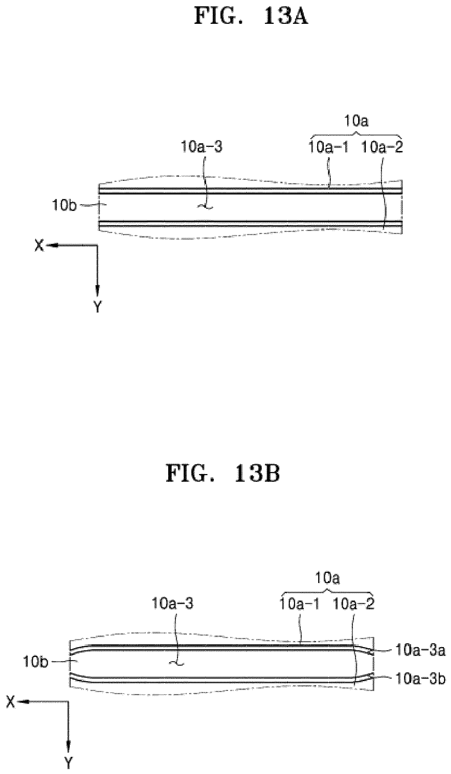

FIGS. 13A to 13C are backside views of the opening area shown in FIG. 12A.

Referring to FIGS. 13A to 13C, a backside shape (e.g., a shape of the display apparatus viewed in a Z axis direction, or a shape of the display apparatus viewed from the bottom to the top with the substrate 10b disposed on the upper portion and the support substrate 10a disposed on the lower portion) of the opening area 10a-3 may be various. As an example, the backside shape of the opening area 10a-3 may be a line shape as shown in FIG. 13A. In this case, the boundary 10a-1a of the first support substrate 10a-1 and the boundary 10a-2a of the second support substrate 10a-2 defining a portion of the opening area 10a-3 may be a straight line. In addition, a portion defining another portion of the opening area 10a-3 and where a slope surface of the first support substrate 10a-1 meets the substrate 10b and a portion where a slope surface of the second support substrate 10a-2 meets the substrate 10b may be straight lines.

In another embodiment, as shown in FIG. 13B, a backside shape of the opening area 10a-3 may have a shape such that at least one of at least a portion of a first end 10a-3a of a slope surface of the first support substrate 10a-1 and at least a portion of a second end 10a-3b of a slope surface of the second support substrate 10a-2 may protrude to the inside of the opening area 10a-3. That is, as shown in FIG. 13B, at least one of the first ends 10a-3a of the slope surface of the first support substrate 10a-1 disposed in a lengthwise direction of the slope surface of the first support substrate 10a-1 may protrude to the opening area 10a-3. In this case, at least one of the boundary 10a-1a of the first support substrate 10a-1 and a boundary where a slope surface of the first support substrate 10a-1 meets a slope of the substrate 10b may protrude to the opening area 10a-3. In addition, as shown in FIG. 13B, at least one of second ends 10a-3b of the slope surface of the second support substrate 10a-2 disposed in the lengthwise direction of the slope surface of the second support substrate 10a-2 may protrude to the opening area 10a-3. In this case, at least one of the boundary 10a-2a of the second support substrate 10a-2 and a boundary where a slope surface of the second support substrate 10a-2 meets a slope of the substrate 10b may protrude to the opening area 10a-3. In addition to the above case, at least one of the entire end of the slope surface of the first support substrate 10a-1 and the entire end of the slope surface of the second support substrate 10a-2 may protrude to the opening area 10a-3. In addition, at least one of a portion of the end of the slope surface of the first support substrate 10a-1 and a portion of the end of the slope surface of the second support substrate 10a-2 may protrude to the opening area 10a-3.

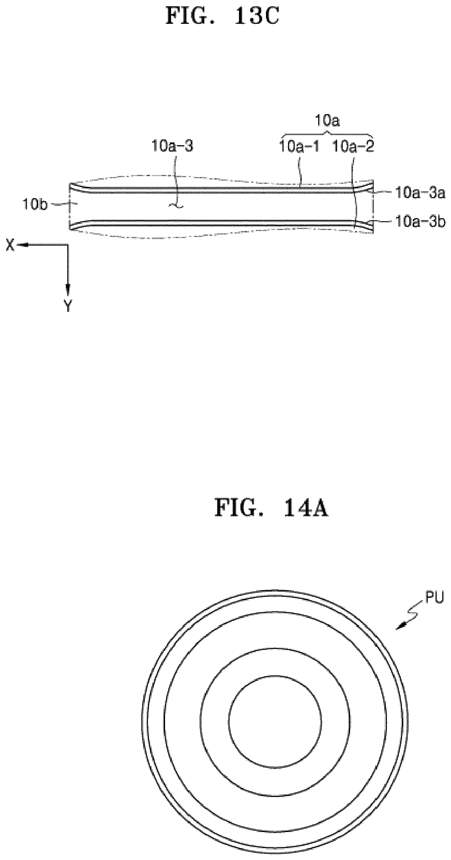

In another embodiment, as shown in FIG. 13C, the end of the opening area 10a-3 may be formed to be extended. In this case, the opening area 10a-3 may be extended from at least one of at least one of the first ends 10a-3a of the slope surface of the first support substrate 10a-1 and at least one of the second ends 10a-3b of the slope surface of the second support substrate 10a-2. As an example, referring to FIG. 13C, at least one of the first end disposed on the upper right among the first ends 10a-3a, the first end disposed on the upper left among the first ends 10a-3a, the second end disposed on the lower right among the second ends 10a-3b, and the second end disposed on the lower left among the second ends 10a-3b may be formed in a direction away from the center of the opening area 10a-3. In this case, at least one of the ends of the opening area 10a-3 may have a shape similar to a funnel shape. In this case, the first end 10a-3a may denote at least a portion of the end of the slope surface of the first support substrate 10a-1, and the second end 10a-3b may denote at least a portion of the end of the slope surface of the second support substrate 10a-2.

The opening area 10a-3 may be formed using a method similar to the manufacturing method shown in FIGS. 6A to 6E, the manufacturing method shown in FIGS. 8A to 8E, or the manufacturing method shown in FIGS. 10A to 10D.

FIGS. 14A to 14D are views showing embodiments of the cutting unit used in the method of manufacturing the display apparatus according to an embodiment.

Referring to FIGS. 14A to 14D, the cutting unit PU may include a cutter having various shapes. As an example, the cutting unit PU may have a disc shape as shown in FIG. 14A. In this case, the lateral shape of the cutting unit PU may be similar to the shape shown in FIG. 6B.

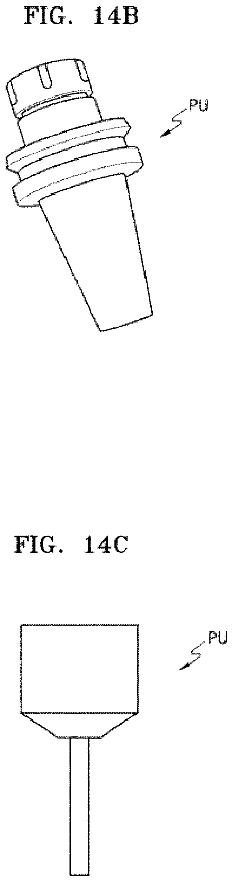

The cutting unit PU may have a cone shape as shown in FIG. 14B. In this case, because a surface where the cutting unit PU is in contact with the support substrate (not shown) is inclined with respect to the lengthwise direction of the cutting unit PU, an inner surface of the reference groove MS-1a processing by the cutting unit PU or a cut cross-section of the support substrate 10a cut along the cutting line CL may have an inclined shape.

As shown in FIG. 14C, a portion of the cutting unit PU configured to form the reference groove MS-1a in the support substrate 10a or form the cutting line CL may have a cylindrical shape. In this case, the inner surface of the reference groove MS-1a or a cut cross-section of the support substrate 10a cut along the cutting line CL may have a straight line shape.

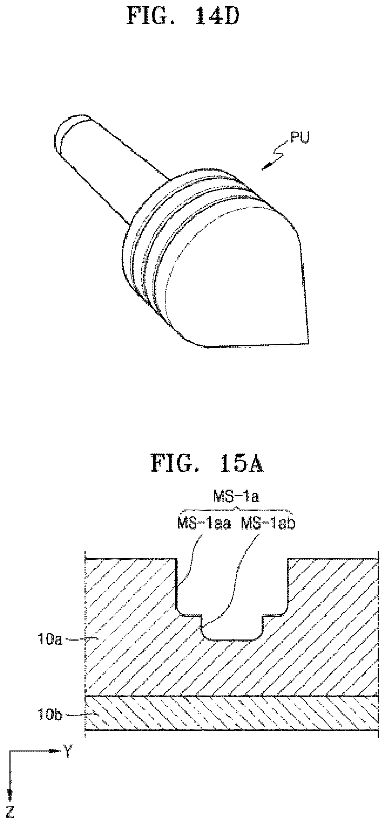

A shown in FIG. 14D, a portion of the cutting unit PU configured to form the reference groove MS-1a in the support substrate 10a or form the cutting line CL may have a conical shape. In this case, the inner surface of the reference groove MS-1a processed by the cutting unit PU or a cut cross-section of the support substrate 10a cut along the cutting line CL may have an inclined shape.

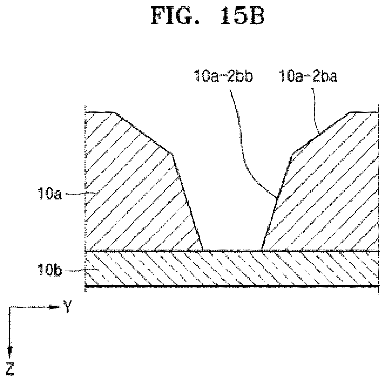

FIGS. 15A and 15B are cross-sectional views of some of the manufacturing of the display apparatus according to another embodiment.

Referring to FIG. 15A, the reference groove MS-1a formed by the cutting unit (not shown) may be formed to have a shape stepped from one surface of the support substrate 10a. As an example, the reference groove MS-1a may include at least two reference grooves. Hereinafter, for convenience of description, the case where the reference groove MS-1a includes two reference grooves is mainly described in detail.

The reference groove MS-1a may include a first reference groove MS-1aa and a second reference groove MS-1ab connected to each other. In this case, the width (e.g., measured in a Y direction in FIG. 15A) of the first reference groove MS-1aa and the width (e.g., measured in a Y direction in FIG. 15A) of the second reference groove MS-1ab may be different from each other. In this case, the width of the first reference groove MS-1aa may be greater than the width of the second reference groove MS-1ab. In this case, the method of forming the reference groove MS-1a may be the same as or similar to the method described with reference to FIG. 6B, 8B, or 10B. Although not shown in the drawing, in the case where the reference groove MS-1a includes three or more reference grooves, the widths of the reference grooves may sequentially increase as the distance from the substrate 10b increases.

When the above operation is completed, the opening area 10a-3 may be formed by spraying etching solution to the reference groove MS-1a. In this case, when the etching solution is sprayed, the reference groove MS-1a may be extended. In this case, at least one of a slope surface of the first support substrate 10a-1 and a slope surface of the second support substrate 10a-2 defining the opening area 10a-3 may include a plurality of slope surfaces having different slope angles. In this case, as shown in FIG. 6E, the slope angle may denote an angle formed by the slope surface with respect to one surface of the substrate 10b.

In the case where the plurality of slope surfaces are formed, as shown in FIG. 15B, not only the slope surface of the second support substrate 10a-2 may include two slope surfaces but also the slope surface of the second support substrate 10a-2 may include three or more slope surfaces. In this case, a slop angle of the plurality of slope surfaces may increase toward the substrate 10b. As an example, in FIG. 15B, a slope angle of a first slope surface 10a-2ba may be less than a slope angle of a second slope surface 10a-2bb.

In the display apparatus according to embodiments, after the substrate is bent, a portion of the support substrate may elastically support a bent portion of the substrate. A method of manufacturing the display apparatus according to embodiments may reduce the occurrence of foreign materials while manufacturing the display apparatus.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A display apparatus comprising:
   a support substrate (10a) including a first support substrate (10a-1) and a second support substrate (10a-) separated from each other; a substrate (10b) disposed on the support substrate (10a);

   a display layer disposed on a portion of the substrate (10b) corresponding to the first support substrate (10a-1); and

a thin-film encapsulation layer (60) disposed to cover the display layer,

wherein one surface of the first support substrate (10a-1) and one surface of the second support substrate (10a-2) facing each other include a slope surface.

2. The display apparatus of claim 1, wherein one of the one surface of the first support substrate (10a-1) and the one surface of the second support substrate (10a-2) facing each other includes a groove (10a-4) formed in a direction away from the other one of the one surface of the first support substrate (10a-1) and the one surface of the second support substrate (10a-2) facing each other.

3. The display apparatus of claim 1 or 2, wherein a maximum width of the groove (10a-4) is in a range exceeding 0 μm and equal to or less than 50 μm, and/or wherein each of the first support substrate (10a-1) and the second support substrate (10a-2) includes a plurality of sides, and

at least one of the plurality of sides of the first support substrate (10a-1) or at least one of the plurality of sides of the second support substrate (10a-2) includes a slope surface.

4. The display apparatus of any of the preceding claims, further comprising a protective layer (10c) disposed on the support substrate (10a) and the substrate (10b).

5. The display apparatus of claim 4, wherein the protective layer (10c) is arranged to overlap a region in which the first support substrate (10a-1) is apart from the second support substrate (10a-2) in a plan view, and/or wherein the protective layer (10c) includes amorphous silicon.

6. The display apparatus of any of the preceding claims, wherein the substrate (10b) is bendable, and/or further comprising a bending protective layer (10c) disposed on a bent portion of the substrate (10b).

7. A method of manufacturing the display apparatus of any of the preceding claims, the method comprising:

disposing a second base substrate (MS-2) on a first base substrate (MS -1);
forming a display layer and a thin-film encapsulation layer (60) on the second base substrate (MS -2);
forming a reference groove (MS1-a) in the first base substrate (MS -1);
disposing an etching protective layer (10c) on the thin-film encapsulation layer (60); and
forming an opening area by spraying an etching solution to the first base substrate (MS -1) and expanding the reference groove (MS1-a).

8. The method of claim 7, wherein forming the reference groove (MS1-a) is accomplished by removing a portion of the first base substrate (MS -1) with a cutter or a laser beam.

9. The method of claim 7 or, further comprising forming a protective layer (10c) on the first base substrate (MS -1).

10. The method of claim 9, wherein the protective layer (10c) overlaps the reference groove (MS1-a) in a plan view, and/or, wherein the protective layer (10c) includes amorphous silicon.

11. The method of any of claims 7 to 10, wherein a depth of the reference groove (MS1-a) has a linear relationship with a taper angle of one surface of the first base substrate (MS -1) disposed around the expanded opening area.

12. The method of any of claims 7 to 11, further comprising forming a groove (10a-4) in a boundary of one surface of the first base substrate (MS -1) defining the opening area, and/or wherein a maximum width of the groove (10a-4) is in a range exceeding 0 μm and equal to or less than 50 μm.

13. The method of any of claims 7 to 12, further comprising disposing a bending protective layer (10c) on the second base substrate (MS -2) to overlap the opening area in a plan view.

14. The method of claim 13, further comprising bending the second base substrate (MS -2) around an arbitrary bending axis overlapping the bending protective layer (10c).

15. The method of any of claims 7 to 14, further comprising separating the first base substrate (MS -1) and the second base substrate (MS -2) on which the display layer and the thin-film encapsulation layer (60) are disposed from the first base substrate (MS -1) and the second base substrate (MS -2) based on a cutting line arranged in a portion apart from an edge of the display layer and the thin-film encapsulation layer (60).

# FIG. 1

# FIG. 2

# FIG. 3

# FIG. 4

# FIG. 5A

# FIG. 5B

FIG. 5C

A

d

10a-2

X

Z

Y

FIG. 6A

DPA    1A  BA  2A    MS-1(MS-2)

B                          B'

60    10a-3

X

Z

Y

# FIG. 6B

# FIG. 6C

## FIG. 6D

## FIG. 6E

FIG. 7

FIG. 8A

# FIG. 8B

# FIG. 8C

# FIG. 8D

CL                       MS

60

X
Z → Y

# FIG. 8E

CT

CL      ELS      60      10a-3

T-2

MS-1               10a-2

Z
X → Y

## FIG. 8F

## FIG. 8G

FIG. 9

FIG. 10A

# FIG. 10B

# FIG. 10C

## FIG. 10D

## FIG. 11

## FIG. 12A

10a

10a-1    10a-2

10a-1a

10a-4

10a-2a

D

Y

X  Z

10b

## FIG. 12B

10a-4

d

10a-2

X

Y

FIG. 12C

FIG. 12D

FIG. 13A

FIG. 13B

# FIG. 13C

# FIG. 14A

FIG. 14B

PU

FIG. 14C

PU

# FIG. 14D

# FIG. 15A

# FIG. 15B

Europäisches
Patentamt

European
Patent Office

Office européen
des brevets

## EUROPEAN SEARCH REPORT

Application Number

EP 23 21 0406

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/202853 A1 (AN HYUNJIN [KR] ET AL) 1 July 2021 (2021-07-01) * paragraphs [0050] – [0051], [0121], [0138] – [0143]; figures 1,2,7A-7D * ----- | 1-15 | INV. H10K59/80 H10K77/10 ADD. H10K102/00 |
| X | EP 3 564 781 A1 (SAMSUNG DISPLAY CO LTD [KR]) 6 November 2019 (2019-11-06) * figures 5,11 * ----- | 1-6 | |
| X | KR 102 403 197 B1 (SAMSUNG DISPLAY CO LTD [KR]) 27 May 2022 (2022-05-27) * paragraphs [0035] – [0039]; figures 5-9 * ----- | 1-3 | |

TECHNICAL FIELDS
SEARCHED       (IPC)

H10K

The present search report has been drawn up for all claims

| Place of search | Date of completion of the search | Examiner |
|---|---|---|
| The Hague | 12 April 2024 | Welter, Steve |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 4 376 579 A1

## ANNEX TO THE EUROPEAN SEARCH REPORT
## ON EUROPEAN PATENT APPLICATION NO.

EP 23 21 0406

This annex lists the patent family members relating to the patent documents cited in the above-mentioned European search report.
The members are as contained in the European Patent Office EDP file on
The European Patent Office is in no way liable for these particulars which are merely given for the purpose of information.

12-04-2024

| Patent document cited in search report | Publication date | Patent family member(s) | Publication date |
|---|---|---|---|
| US 2021202853 A1 | 01-07-2021 | CN 113130588 A | 16-07-2021 |
| | | KR 20210086285 A | 08-07-2021 |
| | | US 2021202853 A1 | 01-07-2021 |
| EP 3564781 A1 | 06-11-2019 | CN 110444678 A | 12-11-2019 |
| | | EP 3564781 A1 | 06-11-2019 |
| | | US 2019341566 A1 | 07-11-2019 |
| | | US 2021367173 A1 | 25-11-2021 |
| | | US 2023301165 A1 | 21-09-2023 |
| KR 102403197 B1 | 27-05-2022 | KR 20180005313 A | 16-01-2018 |
| | | US 2018013095 A1 | 11-01-2018 |